(19)

**Europäisches Patentamt**
**European Patent Office**
**Office européen des brevets**

(11) **EP 4 656 595 A1**

(12) **EUROPEAN PATENT APPLICATION**
published in accordance with Art. 153(4) EPC

(43) Date of publication:
03.12.2025 Bulletin 2025/49

(21) Application number: 24747250.9

(22) Date of filing: 22.01.2024

(51) International Patent Classification (IPC):
$C01B\ 19/00^{(2006.01)}$   $B82Y\ 30/00^{(2011.01)}$
$C09K\ 11/58^{(2006.01)}$   $C09K\ 11/62^{(2006.01)}$
$C09K\ 11/88^{(2006.01)}$   $H01L\ 31/0352^{(2006.01)}$

(52) Cooperative Patent Classification (CPC):
B82Y 30/00; C01B 19/00; C09K 11/08;
C09K 11/58; C09K 11/62; C09K 11/64; C09K 11/88;
C09K 11/89; H10F 77/14

(86) International application number:
PCT/JP2024/001616

(87) International publication number:
WO 2024/157922 (02.08.2024 Gazette 2024/31)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.01.2023 JP 2023010539

(71) Applicants:
• NATIONAL UNIVERSITY CORPORATION TOKAI NATIONAL
HIGHER EDUCATION AND RESEARCH SYSTEM
Nagoya-shi, Aichi 464-8601 (JP)
• Tanaka Precious Metal Technologies Co., Ltd.
Tokyo 103-0025 (JP)

(72) Inventors:
• TORIMOTO Tsukasa
Nagoya-shi, Aichi 464-8601 (JP)
• KAMEYAMA Tatsuya
Nagoya-shi, Aichi 464-8601 (JP)
• MIYAMAE Chie
Nagoya-shi, Aichi 464-8601 (JP)
• SATO Hiroki
Tsukuba-shi, Ibaraki 300-4247 (JP)
• OHSHIMA Yuusuke
Tsukuba-shi, Ibaraki 300-4247 (JP)
• SATO Taisuke
Tsukuba-shi, Ibaraki 300-4247 (JP)

(74) Representative: Weickmann & Weickmann
PartmbB
Postfach 860 820
81635 München (DE)

(54) **SEMICONDUCTOR NANOPARTICLES COMPOSED OF AGAUSE-BASED MULTINARY COMPOUND**

(57) The semiconductor nanoparticle of the present invention is constituted of a compound containing Ag, Au, a chalcogen element essentially including Se, and a metal M, as essential constituent elements. The metal M is at least any one of Al, Ga, In, Tl, Zn, Cd, Hg, and Cu. The total content of Ag, Au, the chalcogen element essentially including Se, and the metal M in the compound constituting the semiconductor nanoparticle of the present invention is 95% by mass or more. The content of the metal M in the compound is preferably 1% by atom or more and 50% by atom or less. The semiconductor nanoparticle of the present invention can exhibit favorable light absorption and emission characteristics in a wavelength region including near infrared region and short-wave infrared region.

(Cont. next page)

FIG. 4

EXAMPLE 1

Ex = 700 nm

EXAMPLE 2

Ex = 700 nm

## Description

FIELD OF THE INVENTION

The present invention relates to a semiconductor nanoparticle including a AgAuSe-based multinary compound, specifically to a semiconductor nanoparticle which is a novel AgAuSe-based multinary compound constituted of Ag, Au, Se and a metal M and which has excellent optical semiconductor characteristics.

DESCRIPTION OF THE RELATED ART

Semiconductors are formed into nanoscale microparticles to exert the quantum confinement effect and exhibit the bandgap depending on the particle size. Therefore, semiconductor nanoparticles can be controlled for the composition and the particle size and regulated for the bandgap to allow the emission wavelength and the absorption wavelength to be arbitrarily set. Semiconductor particles utilizing such characteristics are also referred to as quantum dots (QD), and are expected to be actively used in various technical fields. Considered as application examples of semiconductor nanoparticles include, for example, light emitting elements and fluorescent substances as used in display devices, marker substances for detecting bio-related substances, because semiconductor nanoparticles not only can be controlled for the emission wavelength by particle size adjustment as described above, but also exhibit a sufficiently narrow and stable emission peak width as compared with organic dyes.

Semiconductor nanoparticles can also be controlled for the absorption wavelength, and furthermore also have the properties of having a high quantum efficiency and a high absorbance index. Thus, semiconductor nanoparticles are also studied about use for photoelectric conversion devices or light-receiving devices to be mounted in solar batteries, various light sensors, or the like. In particular, semiconductor nanoparticles are expected to be applied in light-receiving devices for light sensors corresponding to the near infrared region (NIR) or the short-wave infrared region (SWIR). These light sensors corresponding to the long-wavelength region are mounted in LIDAR (Light Detection and Ranging) or SWIR image sensors. LIDAR is a remote sensing system for automobile automatic operations, drones, marine vessels, and the like, and serves as an important device for development of recent automatic operation techniques. SWIR image sensors are devices predicted to be increasingly demanded in future in the fields of food inspection, agriculture, drone, and the like. Application examples of conventional light-receiving devices for light sensors have been often Si thin films. However, sensors with Si thin films are significantly lowered in sensitivity in a wavelength region of 900 nm or more, and therefore cannot be suited for the above applications. Thus, development of light-receiving devices with semiconductor nanoparticles is expected.

There are known, as specific constitutions of semiconductor nanoparticles studied heretofore, semiconductor nanoparticles constituted of a binary compound semiconductor which is a Group 11-Group 16 compound semiconductor such as CdS, CdSe, CdTe, PbS, PbSe, or $Ag_2S$, and a ternary compound semiconductor which is a Group 11-Group 13-Group 16 compound semiconductor such as $AgInTe_2$ (Patent Documents 1 to 4).

Prior Art Document

Patent Document

Patent Document 1
Japanese Patent Application Laid-Open No. 2004-243507
Patent Document 2
Japanese Patent Application Laid-Open No. 2004-352594
Patent Document 3
Japanese Patent Application Laid-Open No. 2017-014476
Patent Document 4
International Publication No. WO2020/054764

SUMMARY OF THE INVENTION

Technical Problem

Although there are known semiconductor nanoparticles of various compositions as described above, semiconductor nanoparticles are still being researched and optimal one in consideration of usefulness is not found. In particular, there are few semiconductor nanoparticles having suitable response characteristics corresponding to the near infrared region (NIR) or the short-wave infrared region (SWIR) described above.

With reference to conventional semiconductor nanoparticles described above, PbS nanoparticles can correspond to the near infrared region (NIR) and the short-wave infrared region (SWIR). However, Pb is included in specified hazardous substances prescribed as restricted-use substances for electrical and electronic equipment in the RoHS Directive (Restriction of the use of certain Hazardous Substances in electrical and electronic equipment) in EU, and is far from metal elements to be frequently used in future from the viewpoint of environmental burden.

Furthermore, even in view of applications other than light-receiving devices for light sensors or the like, some of conventional semiconductor nanoparticles include Cd besides Pb, and there are few usable semiconductor nanoparticles in terms of a requirement for biocompatibility (low-toxic composition) or the like.

The present invention here proposes a semiconductor nanoparticle of a novel constitution with no reported example heretofore, in which the semiconductor nanoparticle has suitable optical semiconductor characteristics and furthermore is provided also in consideration of usefulness such as biocompatibility, and particularly presents a semiconductor nanoparticle capable of corresponding to the near infrared region (NIR) and the short-wave infrared region (SWIR) and exhibiting suitable light absorption and emission characteristics in these wavelength regions.

Solution to Problem

The present inventors have focused on a semiconductor nanoparticle including a chalcogenide compound containing both two kinds of metals (precious metals) of Ag and Au, as a new semiconductor nanoparticle. As shown in the above conventional techniques, Ag chalcogenide compound ($Ag_2S$) nanoparticles are known to exhibit optical semiconductor characteristics. Au can also exhibit such characteristics. Both precious metals, Ag and Au, are relatively chemically stable metals, and have been known as metals having biocompatibility, from long ago. Accordingly, it is to be considered that specific studies on a semiconductor nanoparticle of a ternary chalcogenide compound containing both Ag and Au are technically meaningful.

Furthermore, the present inventors have also studied optimization of a chalcogen element constituting a compound together with Ag and Au, and as a result, have confirmed that a semiconductor nanoparticle which includes a AgAuSe-based compound containing Ag and Au as well as a chalcogen element essentially including Se (selenium) has characteristics capable of contributing to solving the problem of the present invention.

Studies by the present inventors can provide constitution of a suitable semiconductor nanoparticle even with a AgAuS ternary compound containing S (sulfur) applied as a chalcogen element, as long as only the viewpoint of exertion of optical semiconductor characteristics is considered. However, the present inventors have confirmed that such a nanoparticle of a AgAuS ternary compound is insufficient in terms of optical responsivity in the near infrared region (NIR) and the short-wave infrared region (SWIR), as another object of the present invention. The present inventors have confirmed that application of Se as an essential chalcogen element can allow optical responsivity to be exhibited in the long-wavelength region.

The present inventors have then studied characteristics of a semiconductor nanoparticle including a AgAuSe-based compound and tried to find an optimal constitution based on this, and as a result, have found a nanoparticle including a AgAuSe-based multinary compound, in which a predetermined metal element (M) is added to a AgAuSe-based compound.

Specifically, the present invention solving the above problems is drawn to a semiconductor nanoparticle including a compound containing Ag, Au, a chalcogen element essentially including Se, and a metal M, as essential constituent elements, wherein the metal M is at least any one of Al, Ga, In, Tl, Zn, Cd, Hg, and Cu, and a total content of Ag, Au, the chalcogen element essentially including Se, and the metal M in the compound is 95% by mass or more.

Hereinafter, a constitution and a production method of the semiconductor nanoparticle including a AgAuSe-based multinary compound semiconductor of the present invention are described. In the present specification, for convenience, the chalcogenide compound constituted of Ag, Au, a chalcogen element essentially including Se is referred to as a "AgAuSe-based compound". The multinary chalcogenide compound, which is quaternary or higher, in which at least one metal M is added to the AgAuSe-based compound, as a subject of the present invention, is referred to as "AgAuSe-based multinary compound".

A. Constitution of the semiconductor nanoparticle of the present invention

A-1. Chemical composition of semiconductor nanoparticle

As described above, the semiconductor nanoparticle of the present invention is constituted of a AgAuSe-based multinary compound, in which a metal M is added to the AgAuSe-based compound. In the present invention, Ag and Au are essential metals as metal elements (transition metal elements) constituting the AgAuSe-based compound as a basic compound in the present invention. The AgAuSe-based multinary compound in the present invention is varied in characteristics due to the abundance ratio between Ag and Au in the compound. In the present invention, the ratio $(x/(x + y))$ of the number of Ag atoms based on the total of the number $(x)$ of Ag atoms and the number $(y)$ of Au atoms in the compound constituting the nanoparticle is preferably 0.20 or more and 0.95 or less. The ratio of the number of Ag atoms is more preferably 0.40 or more, further preferably 0.5 or more, particularly preferably 0.6 or more. The ratio of the number of Ag atoms is more preferably 0.90 or less, further preferably 0.88 or less. Such a composition range provides a clear increase effect of the emission quantum efficiency or the like.

Se is also an essential constituent element for the AgAuSe-based multinary compound in the present invention. Se is selected as a chalcogen element in the present invention in order to impart effective optical response characteristics in both the near infrared region (NIR) and the short-wave infrared region (SWIR), to the semiconductor nanoparticle. A AgAuS ternary compound in which S is applied as a chalcogen element exhibits effective optical response characteristics and emission peak in a wavelength region near 800 nm, but such a peak is liable to be attenuated in a wavelength region of 900 nm or more. In the present invention, application of Se as an essential chalcogen element can allow suitable optical response characteristics and emission peak to be exhibited even in a wavelength region of 900 nm or more. This effect is presumed to occur due to a decrease in orbital energy difference between each metal and a chalcogen element in the compound with Se larger in mass than S being applied.

A chalcogen element essentially including Se is contained in the AgAuSe-based multinary compound so that charge compensation is made for Ag, Au, and the metal M. Therefore, the content of the chalcogen element essentially including Se changes with the content and the valence of each of Ag, Au, and the metal M. The content of the chalcogen element essentially including Se in the AgAuSe-based multinary compound is preferably 25% by atom or more and 60% by atom or less. The content of the chalcogen element essentially including Se is more preferably 30% by atom or more and 45% by atom or less.

The metal M added for improvement of characteristics of the AgAuSe-based compound in the present invention is at least any one of Al, Ga, In, Tl, Zn, Cd, Hg, and Cu being elements belonging to Group 11 elements to Group 13 elements. These metal elements generate the changes in characteristics, including the enhancement effect of the emission quantum efficiency and shifting of the absorption wavelength of the AgAuSe-based compound. Examples of a more preferred metal M include In, Cu, Zn, and Ga.

The AgAuSe-based multinary compound constituting the semiconductor nanoparticle of the present invention is changed in structure and characteristics depending on the type and the content of the metal M. The content of the metal M in the compound is preferably 1% by atom or more and 50% by atom or less. If the content of the metal M is less than 1% by atom, no substantial change from the AgAuSe-based compound is obtained. If the content is more than 50% by atom, the improvement effect of characteristics, for example, the quantum efficiency, is largely reduced. When the metal M is an element belonging to Group 13 elements such as Al, Ga, and In, the content of the metal M is more preferably 1% by atom or more and 15% by atom or less.

The semiconductor nanoparticle of the present invention is constituted of a AgAuSe-based multinary compound containing Ag, Au, a chalcogen element essentially including Se, and a metal M, as essential constituent elements. The total content of Ag, Au, the chalcogen element essentially including Se, and the metal M in this AgAuSe-based multinary compound is 95% by mass or more relative to the entire compound. Examples of an element which can be contained, other than Ag, Au, Se, and the metal M as essential constituent elements are considered to be Ge, Si, Sn, Pb, and O, and these elements are acceptable as long as these are contained at less than 5% by mass. Herein, the total content of Ag, Au, the chalcogen element essentially including Se, and the metal M in the compound is preferably 99% by mass or more, more preferably 99.9% by mass or more. The composition value of the compound is here a value with respect to the AgAuSe-based multinary compound constituting the semiconductor nanoparticle, and a component of a protective agent described below is not included.

Herein, the AgAuSe-based multinary compound constituting the semiconductor nanoparticle of the present invention is defined as containing Se as an essential chalcogen element, and therefore can contain a chalcogen element other than Se, such as S. For example, when any other chalcogen element than Se is used during doping with the metal M in a production process of the semiconductor nanoparticle, described below, a semiconductor nanoparticle including Se and S is sometimes formed. However, a particularly preferred aspect from the viewpoints of the optical responsivity and the emission quantum efficiency in a long-wavelength region is a semiconductor nanoparticle of a AgAuSe-based multinary compound in which only Se is adopted as a chalcogen element. A suitable range of the Se content is here the same as a suitable range of the content of the above chalcogen element.

A-2. Structure of the semiconductor nanoparticle of the present invention

The structure of the semiconductor nanoparticle including a AgAuSe-based multinary compound of the present invention is not particularly limited in terms of the distribution state of each atom of Ag, Au, Se, and the metal M as constituent elements. Examples of the structure of the compound constituting the semiconductor nanoparticle include a compound in a state where a AgAuSe-based compound containing Ag, Au, and Se is doped with the metal M. Such a doped state in this case corresponds to a state where a metal M atom substitutes for a lattice of a semiconductor compound crystal including the AgAuSe-based compound and/or penetrates between such lattices.

The compound constituting the semiconductor nanoparticle of the present invention may be constituted of a single phase or a plurality of phases. A particle including a plurality of phases can also have a so-called core-shell structure. The core-shell structure may have a structure where the AgAuSe-based compound containing Ag, Au, and Se serves as a core (core compound), and the metal M or a compound essentially containing the metal M and containing at least any one of Ag, Au, and Se serves as a shell (shell compound) and covers at least one portion of a surface of the core compound. It is considered with respect to the semiconductor nanoparticle of the core-shell structure that modification of a surface defect of the AgAuSe-based compound serving as the core, with the metal M in the shell, leads to enhancement of characteristics of the AgAuSe-based compound. In this case, the shell compound may be constituted of only the metal M or constituted of a compound of the metal M and at least any one of Ag, Au, and Se (for example, $AgMSe_2$, etc.), or may be a mixture of these. Any of these structures may each have a regular or irregular element distribution in the AgAuSe-based multinary compound to be formed into the semiconductor nanoparticle.

A scanning transmission electron microscope (Scanning TEM) can be here suitably used in analysis of the composition and the structure of the semiconductor nanoparticle of the present invention. In particular, a high angle annular dark field scanning TEM (HAADF-STEM) can provide a scattered image reflecting the composition information of the nanoparticle, and can be combined with an energy dispersive X-ray spectrometer (EDX) or the like, to figure out the distribution state of Ag, Au, Se, and the metal M, and the composition of the entire nanoparticle.

The semiconductor nanoparticle of the present invention preferably has an average particle size of 2 nm or more and 20 nm or less. The particle size of the semiconductor nanoparticle is associated with the adjustment action of the bandgap with the quantum confinement effect. The above average particle size is preferred for exertion of suitable emission and light absorption characteristics with bandgap adjustment. The average particle size of the semiconductor nanoparticle can be here obtained with observation of a plurality of (preferably 100 or more) particles with an electronic microscope such as TEM, measurement of the particle size of each particle, and calculation of the particle number average.

A-3. Optical semiconductor characteristics of the semiconductor nanoparticle of the present invention

As described above, the semiconductor nanoparticle is adjusted with respect to the bandgap with the quantum confinement effect depending on the particle size, and varied in light absorption characteristics. The absorption edge wavelength on the long-wavelength side of the absorption spectrum of the semiconductor nanoparticle of the present invention is preferably 800 nm or more. Thus, the semiconductor nanoparticle has absorptivity and responsivity to light in the visible region to the near-infrared region. A more preferred aspect of the present invention can be drawn to a semiconductor nanoparticle in which the absorption edge wavelength on the long-wavelength side of the absorption spectrum is 850 nm or more. When the semiconductor nanoparticle of the present invention is subjected to emission spectrum measurement, the peak wavelength in the emission spectrum preferably appears in a longer wavelength region than 900 nm, more preferably appears in a longer wavelength region than 1000 nm.

A-4. Usage aspect of the semiconductor nanoparticle of the present invention

The semiconductor nanoparticle of the present invention, which is applied to and supported on an appropriate substrate or carrier, can be thus applied in various applications described above, such as a light-emitting device. The constitutions, shapes and dimensions of such substrate or carrier are not particularly limited. Examples of a plate-, foil- or film-like substrate include glass, quartz, silicon, ceramics or metal. Examples of a particulate or powdery carrier include inorganic oxides such as $ZnO$, $TiO_2$, $WO_3$, $SnO_2$, $In_2O_3$, and $Al_2O_3$. The semiconductor nanoparticle may be supported on the inorganic oxide carrier and furthermore fixed to the substrate.

When the semiconductor nanoparticle is applied to and supported on the substrate or carrier, a solution or slurry or ink in which the semiconductor nanoparticle is dispersed in an appropriate dispersion medium is often used as described above. The dispersion medium usable in the solution or the like is chloroform, toluene, cyclohexane, hexane, or the like. A usable application method of the solution or the like of the semiconductor nanoparticle can be dipping or a spin coating method, and a usable supporting method of the semiconductor nanoparticle can be any of various methods such as a dropping method, an impregnation method, and an adsorption method.

The semiconductor nanoparticle of the present invention preferably includes a protective agent for suppressing aggregation during the synthesis of the semiconductor nanoparticle or in dispersing of the semiconductor nanoparticle in the dispersion medium as described above. The protective agent is preferably at least any one of an alkylamine having 4 or more and 20 or less alkyl chain carbon atoms, an alkenylamine having 4 or more and 20 or less alkenyl chain carbon atoms, an alkylcarboxylic acid having 3 or more and 20 or less alkyl chain carbon atoms, an alkenylcarboxylic acid having 3 or more and 20 or less alkenyl chain carbon atoms, an alkanethiol having 4 or more and 20 or less alkyl chain carbon atoms, a trialkylphosphine having 4 or more and 20 or less alkyl chain carbon atoms, a trialkylphosphine oxide having 4 or more and 20 or less alkyl chain carbon atoms, triphenylphosphine, and triphenylphosphine oxide. Such a protective agent is bound to a surface of the semiconductor nanoparticle to cover at least one portion of the surface, and inhibit the semiconductor nanoparticle from being aggregated in a dispersion liquid, thereby providing a homogeneous solution or the like. Such a protective agent is added together with a raw material, to the reaction system, to synthesize a nanoparticle having a suitable average particle size in a synthesis process of the semiconductor nanoparticle. Such a protective agent can be applied in a single form of the above alkylamine, alkenylamine, alkylcarboxylic acid, alkenylcarboxylic acid, alkanethiol, trialkylphosphine, trialkylphosphine oxide, triphenylphosphine, and triphenylphosphine oxide, or as a combination of a plurality of these protective agents.

B. Method for producing the semiconductor nanoparticle of the present invention

Next, the method for producing the semiconductor nanoparticle of the present invention is described. The semiconductor nanoparticle of the present invention includes a AgAuSe-based multinary compound, in which the AgAuSe-based compound is doped with the metal M. A first method for producing the nanoparticle of the AgAuSe-based multinary compound is a method in which precursors containing respective elements of Ag, Au, Se, and the metal M (Ag precursor, Au precursor, Se precursor, and metal M precursor) are simultaneously reacted to synthesize the AgAuSe-based multinary compound (this synthesis method may be referred to as "direct synthesis"). A second production method is a method in which nanoparticles of the AgAuSe-based compound are synthesized, and the metal M is added and doped to this nanoparticle to synthesize the AgAuSe-based multinary compound (this synthesis method may be referred to as two-step synthesis). Hereinafter, the method for producing the semiconductor nanoparticle, to which each of the synthesis methods is applied, is described.

B-1. Method for producing semiconductor nanoparticle by direct synthesis

Production of the nanoparticle of the AgAuSe-based multinary compound by direct synthesis includes mixing the Ag precursor and the Au precursor with the Se precursor and the metal M precursor in a reaction solvent and heating a reaction system including the resulting mixture at a temperature of 30°C or more and 200°C or less.

The Ag precursor and the Au precursor applied as raw materials are a Ag salt or a Ag complex, and a Au salt or a Au complex, respectively. The Ag precursor and the Au precursor are preferably a salt or complex containing monovalent Ag and one containing monovalent Au, respectively. The Au precursor used may be here a precursor containing trivalent Au. This is because trivalent Au is reduced to monovalent Au with the solvent, the coexisting Se precursor, or the like, during synthesis of the semiconductor nanoparticle.

Examples of a suitable Ag precursor include silver acetate (Ag(OAc)), silver nitrate, silver carbonate, silver oxide, silver oxalate, silver chloride, silver iodide, silver(I) cyanide, and silver diethyldithiocarbamate. Examples of a suitable Au precursor include chloro(dimethylsulfide)gold(I) (($CH_3$)$_2$SAuCl), Au resinate ($C_{10}H_{18}Au_2S_2$: CAS68990-27-2), gold(I) iodide, gold(I) sulphite, chlorauric acid(III), gold(III) acetate, gold(I) cyanide, gold(III) cyanide, and 1,10-phenanthroline gold(III).

The Se compound applicable as the Se precursor can be a Se compound such as selenourea (Se=C($NH_2$)$_2$), selenocysteine, trioctylphosphine selenide, triphenylphosphine selenide, diphenyl diselenide, or dibenzyl diselenide, besides powdery selenium.

Examples of the compound serving as the metal M precursor include chloride, sulfide, nitrate, acetate, sulfate, sulfamate, and stearate of the metal M. Examples include indium chloride, indium acetate, indium diethyldithiocarbamate, copper chloride, copper acetate, zinc stearate, and zinc acetate.

The composition of the AgAuSe-based multinary compound to be synthesized can be adjusted with the ratio of the amounts of the Ag precursor and the Au precursor loaded. The amounts of the Ag precursor and the Au precursor loaded for providing a suitable AgAuSe-based multinary compound are preferably set so that, when a is the number of Ag atoms in the Ag precursor and b is the number of Au atoms in the Au precursor, the ratio (a/(a + b): hereinafter, sometimes referred to as ratio of Ag loaded) of the number of Ag atoms based on the total of these numbers is 0.20 or more and 0.95 or less. The ratio of Ag loaded is more preferably set to 0.4 or more.

The amount of the Se precursor loaded in the reaction system can be set in a relatively wide range relative to the amounts of Ag, Au, and the metal M loaded. The reason is because, even if excess Se is present in the reaction system, the Se precursor has a small effect on the composition of the AgAuSe-based multinary compound.

As described above, a protective agent is preferably bound to the AgAuSe-based multinary compound in the semiconductor nanoparticle of the present invention. Therefore, a protective agent is preferably added together with the Ag precursor, the Au precursor, and the like, to the above reaction system. A preferred protective agent added here is at least any one of an alkylamine having 4 or more and 20 or less alkyl chain carbon atoms, an alkenylamine having 4 or more and 20 or less alkenyl chain carbon atoms, an alkylcarboxylic acid having 3 or more and 20 or less alkyl chain carbon atoms, an alkenylcarboxylic acid having 3 or more and 20 or less alkenyl chain carbon atoms, an alkanethiol having 4 or more and 20 or less alkyl chain carbon atoms, a trialkylphosphine having 4 or more and 20 or less alkyl chain carbon atoms, a trialkylphosphine oxide having 4 or more and 20 or less alkyl chain carbon atoms, triphenylphosphine, and triphenylphosphine oxide.

The reaction system in synthesis of the semiconductor nanoparticle can also provide a nanoparticle in no solvent, but a solvent is preferably used. When the solvent is used, for example, octadecene, tetradecane, oleic acid, oleylamine, dodecanethiol, or any mixture of these solvents can be applied.

A reaction system constituted of the Ag precursor, the Au precursor, the Se precursor, the metal M precursor, and the protective agent is heated to synthesize a AgAuSe-based multinary compound nanoparticle. The heating temperature (reaction temperature) is here set to 30°C or more and 200°C or less. A heating temperature of less than 30°C hardly allows synthesis of the AgAuSe-based multinary compound to progress. In this regard, a heating temperature of more than 200°C has the problem of sometimes providing a nanoparticle singly formed with Au and leading to no production of any compound having a desired composition. The average particle size of the semiconductor nanoparticle, although increases along with increase of the reaction temperature, less exceeds a suitable average particle size as long as the reaction temperature falls within the above temperature range. A more suitable reaction temperature is 40°C or more and 120°C or less.

The reaction time (heating time) can be adjusted with the amounts of raw materials loaded, and is preferably set to 5 minutes or more and 120 minutes or less. The reaction time is more preferably set to 10 minutes or more, further preferably 15 minutes or more. The reaction system is here preferably stirred during synthesis reaction of the semiconductor nanoparticle.

After completion of the synthesis reaction of the semiconductor nanoparticle, the reaction system is, if necessary, cooled to recover the semiconductor nanoparticle. The semiconductor nanoparticle may be here precipitated with addition of an alcohol (ethanol, methanol, or the like) serving as a poor solvent or by centrifugation or the like and thus recovered, and furthermore washed with alcohol (ethanol, methanol, or the like) once and then uniformly dispersed in a good solvent such as chloroform.

B-2. Method for producing semiconductor nanoparticle by two-step synthesis

The semiconductor nanoparticle of the AgAuSe-based multinary compound of the present invention can also be produced by doping of a nanoparticle of a AgAuSe-based compound with the metal M. In this case, the AgAuSe-based multinary compound is synthesized with synthesis of a AgAuSe-based compound and then reaction with the metal M precursor.

A nanoparticle of the AgAuSe-based compound can be synthesized with a reaction system formed with the Ag precursor and the Au precursor mixed with the Se precursor in a reaction solvent, and heated at a temperature of 30°C or more and 200°C or less.

The Ag precursor, the Au precursor, and the Se precursor usable as raw materials of the AgAuSe-based compound are the same metal salts or metal complexes as in the method for producing the AgAuSe-based multinary compound by direct synthesis as described above. The amounts of the Ag precursor, the Au precursor, and the Se precursor loaded for AgAuSe-based compound synthesis may also be the same amounts as in the above direct synthesis of the AgAuSe-based multinary compound. Furthermore, use of the solvent and the protective agent for formation of the reaction system is also set to the same as in the direct synthesis of the AgAuSe-based multinary compound.

The heating temperature (reaction temperature) of a reaction system constituted of the Ag precursor, the Au precursor, the Se precursor and the protective agent is set to 30°C or more and 200°C or less. A heating temperature of less than 30°C hardly allows synthesis of the AgAuSe-based compound to progress. A more suitable reaction temperature is 40°C or more and 120°C or less. The heating time (reaction time) is preferably set to 1 minute or more and 120 minutes or less. After completion of the synthesis reaction of the semiconductor nanoparticle of the AgAuSe-based compound, the nanoparticle can be recovered as described above and thereafter is subjected to doping with the metal M.

The nanoparticle of the AgAuSe-based compound, synthesized as described above, is a compound represented by compositional formula of $Ag_1Au_7Se_4$, $AgAu_3Se_2$, $Ag_3Au_5Se_4$, $AgAuSe$, $Ag_5Au_3Se_4$, $Ag_3AuSe_2$, or $Ag_7AuSe_4$, or a compound approximated by the compositional formula. Examples here include, in addition to compounds having stoichiometric compositions described above, a compound having a composition not included in stoichiometric compositions described above. Such a stoichiometric composition described above or a stoichiometric composition not included in stoichiometric compositions described above, or a mixed phase of these compositions may be adopted.

The doping of the AgAuSe-based compound with the metal M can also be carried out in no solvent, and is preferably performed in a solvent. The solvent used here can be the same as in above the reaction system of the AgAuSe-based compound. The reaction system including the nanoparticle of the AgAuSe-based compound produced as above may be directly utilized, or the nanoparticle may be recovered with the above separation procedure and then re-dispersed in a solvent and thus formed into a reaction system.

In a step of adding the metal M to the AgAuSe-based compound nanoparticle, a metal M compound is added as the metal M precursor to· a reaction system, mixed and heated. The metal M precursor applied here can be the same metal salt or metal complex as in direct synthesis of the AgAuSe-based multinary compound. A suitable range of the amount of the metal M precursor loaded in the reaction system is also the same as in the direct synthesis.

When the doping with the metal M is carried out in the two-step synthesis, a chalcogen element may be added together with the metal M precursor to the reaction system, for charge compensation for conversion of the AgAuSe-based compound into the AgAuSe-based multinary compound. The chalcogen element is not limited to Se and S may also be added. For example, not only single sulfur, but also a compound such as thiourea, alkylthiourea, thioacetamide or alkanethiol, or a compound such as a β-dithione compound, a dithiol compound, xanthogenate or diethyldithiocarbamate may also be used. It is not essential to add the chalcogen element in doping of the AgAuSe-based compound nanoparticle with the metal M.

The doping with the metal M progresses with heating of a reaction system including the AgAuSe-based compound and the metal M precursor, and a chalcogen element optionally added. The heating temperature is here preferably 30°C or more and 200°C or less. A heating temperature of less than 30°C hardly allows the doping with the metal M to progress. In this regard, a heating temperature of more than 200°C may cause decomposition of the AgAuSe-based compound. A more suitable reaction temperature is 100°C or more and 150°C or less. The heating time (reaction time) can be adjusted with the amount of each component loaded in the reaction system, and is preferably set to 5 minutes or more and 60 minutes or less. The reaction system is preferably stirred.

The above reaction process including adding the metal M can synthesize a semiconductor nanoparticle including a AgAuSe-based multinary compound. The semiconductor nanoparticle can be then recovered as in the production method by direct synthesis.

Advantageous Effects of the Invention

As described above, the present invention is drawn to a semiconductor nanoparticle including a AgAuSe-based multinary compound, in which a metal M is added to a AgAuSe-based compound. The AgAuSe-based compound is formed into a nanoparticle to exert optical semiconductor characteristics, and the compound to which a metal M such as In is added thus further exerts suitable characteristics.

The semiconductor nanoparticle including a AgAuSe-based multinary compound of the present invention includes a low-toxic element having biocompatibility, as a main constituent element, and therefore can be expected to be applied to not only a common semiconductor device such as a light-emitting device, but also a bioavailable marker or the like.

The semiconductor nanoparticle of the present invention has improved emission and light absorption characteristics in the near-infrared region. In recent years, photoelectric conversion devices in which responsivity in the near-infrared region counts have been light-receiving devices to be applied to LIDAR or SWIR image sensors. The semiconductor nanoparticle of the present invention is expected to be utilized for such a photoelectric conversion device to be operated in the near-infrared region.

BRIEF DESCRIPTION OF THE DRAWINGS

Fig. 1 shows TEM images of semiconductor nanoparticles of Example 1 and Example 2 (AgAuSeln), Reference Example 1 (AgAuSe), and Reference Example 2 (AgAuS) of First Embodiment.
Fig. 2 illustrates absorption spectra of semiconductor nanoparticles of Example 1 and Example 2 (AgAuSeln) of First Embodiment.
Fig. 3 illustrates absorption spectra of semiconductor nanoparticles of Reference Example 1 (AgAuSe) and Reference Example 2 (AgAuS) of First Embodiment.
Fig. 4 illustrates emission spectra of semiconductor nanoparticles of Example 1 and Example 2 (AgAuSeln) of First Embodiment.
Fig. 5 illustrates emission spectra of semiconductor nanoparticles of Reference Example 1 (AgAuSe) and Reference Example 2 (AgAuS) of First Embodiment.
Fig. 6 shows TEM images of AgAuSeln nanoparticles synthesized in the amount of In loaded adjusted in Second Embodiment.
Fig. 7 illustrates measurement results of absorption spectra of AgAuSeln nanoparticles synthesized in the amount of In loaded adjusted in Second Embodiment.
Fig. 8 illustrates emission spectra of AgAuSeln nanoparticles synthesized in the amount of In loaded adjusted in Second Embodiment.

Fig. 9A shows TEM images of AgAuSeIn nanoparticles synthesized for a reaction time of 20 minutes at the ratio of Ag loaded adjusted in Third Embodiment.

Fig. 9B shows TEM images of AgAuSeIn nanoparticles synthesized for a reaction time of 10 minutes at the ratio of Ag loaded adjusted in Third Embodiment.

Fig. 10A illustrates absorption spectra of AgAuSeIn nanoparticles synthesized for a reaction time of 20 minutes at the ratio of Ag loaded adjusted in Third Embodiment.

Fig. 10B illustrates absorption spectra of AgAuSeIn nanoparticles synthesized for a reaction time of 10 minutes at the ratio of Ag loaded adjusted in Third Embodiment.

Fig. 11A illustrates emission spectra of AgAuSeIn nanoparticles synthesized for a reaction time of 20 minutes at the ratio of Ag loaded adjusted in Third Embodiment.

Fig. 11B illustrates emission spectra of AgAuSeIn nanoparticles synthesized for a reaction time of 10 minutes at the ratio of Ag loaded adjusted in Third Embodiment.

Fig. 12 illustrates XRD diffraction patterns of AgAuSeIn nanoparticles (reaction times of 20 minutes and 10 minutes) synthesized at ratios of Ag loaded of 0.5 and 0.75 in Third Embodiment.

Fig. 13 shows TEM images of AgAuSeIn nanoparticles synthesized for reaction times adjusted in Fourth Embodiment.

Fig. 14 illustrates absorption spectra of AgAuSeIn nanoparticles synthesized for reaction times adjusted in Fourth Embodiment.

Fig. 15 illustrates emission spectra of AgAuSeIn nanoparticles synthesized for reaction times adjusted in Fourth Embodiment.

Fig. 16 illustrates XRD diffraction patterns of AgAuSeIn nanoparticles synthesized for reaction times of 0.5 and 0.75 in Fourth Embodiment.

## DETAILED DESCRIPTION OF THE PREFERRED EMBODIMENTS

First Embodiment: Hereinafter, Embodiments of the present invention are described. In the present Embodiment, each semiconductor nanoparticle including a AgAuSe-based multinary compound (AgAuSeIn), with In included as a metal M, was synthesized by the above two synthesis methods. These semiconductor nanoparticles were subjected to compositional analysis and also evaluated with respect to optical response characteristics.

Example 1: In this Example, AgAuSeIn nanoparticles were synthesized with the direct synthesis. A test tube was loaded with 0.075 mmol of silver acetate (Ag(OAc)) as a Ag precursor, 0.025 mmol of chloro(dimethylsulfide)gold(I) as a Au precursor, 0.10 mmol of indium acetate (In(OAc)$_3$) as an In precursor being a metal M, and 0.20 mmol of selenourea as a Se precursor. In the mixture, 2.9 mL of oleylamine (OLA) as a solvent and 0.1 mL of 1-dodecanethiol (DDT) as a protective agent were added.

A stirrer was placed in the test tube loaded with the above raw materials and solvent, and purged with nitrogen three times, and thereafter the mixture was stirred under heating with a hot stirrer at a reaction temperature of 50°C for 10 minutes. After completion of the reaction, the mixture was allowed to cool for 20 minutes and then transferred to a small test tube, and centrifuged at 4000 rpm for 5 minutes to separate a supernatant solution and a precipitate.

Thereafter, 4 cm$^3$ of methanol was added as a poor solvent to the supernatant solution to generate a precipitate, and the precipitate was recovered with centrifugation at 4000 rpm for 5 minutes. After this precipitate was dispersed in 4 cm$^3$ of ethanol further added, centrifugation was performed under the same conditions to remove a by-product and the solvent and thus purify AgAuSeIn compound nanoparticles.

The AgAuSeIn compound nanoparticles obtained with the above operations were dispersed in 3 cm$^3$ of chloroform to give a dispersion liquid of AgAuSeIn semiconductor nanoparticles. This dispersion liquid was transferred to a sample bottle, subjected to purging with nitrogen, thereafter protected from light, and refrigerated and stored.

Example 2: In this Example, AgAuSeIn nanoparticles were synthesized with the two-step synthesis. In this Example, AgAuSe nanoparticles as a AgAuSe-based compound were first synthesized and doped with In to synthesize AgAuSeIn nanoparticles.

The AgAuSe nanoparticle was synthesized as follows. A test tube was loaded with 0.3 mmol of silver acetate as a Ag precursor, 0.1 mmol of chloro(dimethylsulfide)gold(I) as a Au precursor, and 0.20 mmol of selenourea as a Se precursor. Furthermore, 2.9 mL of oleylamine as a solvent and 0.1 mL of 1-dodecanethiol as a protective agent were added.

The interior of the test tube was purged with nitrogen, and thereafter the mixture was stirred under heating with a hot stirrer at a reaction temperature of 50°C for 10 minutes. After completion of the reaction, the mixture was allowed to cool for 20 minutes and then transferred to a small test tube, and centrifuged at 4000 rpm for 5 minutes to separate a supernatant solution and a precipitate. Thereafter, the precipitate was recovered and purified in the same manner as in Example 1 to give AgAuSe nanoparticles.

Then, $1.0 \times 10^{-5}$ mmol of the AgAuSe nanoparticles obtained as described above, $4.13 \times 10^{-6}$ mol of indium

chloride ($InCl_3$) as an In precursor, and $6.19 \times 10^{-6}$ mol of thioacetamide as a S compound were mixed with 3.0 mL of dehydrated oleylamine as a solvent, and heated to dope the AgAuSe nanoparticles with In. The mixture was heated at a heating temperature of 110°C for 15 minutes. After completion of the reaction, the resultant was allowed to cool for 20 minutes and then transferred to a small test tube, and centrifuged at 4000 rpm for 5 minutes to separate a supernatant solution and a precipitate. Thereafter, AgAuSe(S)In nanoparticles were purified in the same manner as above and thus recovered, to provide a dispersion liquid in the same manner as in Example 1.

Reference Example 1: In order to confirm the effect of doping the AgAuSe-based compound with In (metal M), the AgAuSe compound nanoparticles synthesized in Example 2 described above were evaluated without being doped with In.

Reference Example 2: AgAuS ternary compound nanoparticles in which S is applied as a chalcogen element forming a compound with Ag and Au were synthesized as follows.

A test tube was loaded with 0.3 mmol of silver acetate as a Ag precursor, 0.1 mmol of chloro(dimethylsulfide) gold(I) as a Au precursor, 0.2 mmol of thiourea as a S precursor, 2.9 mL of oleylamine as a solvent, and 0.1 mL of 1-dodecanethiol as a protective agent.

After purging with nitrogen in the same manner as above, the mixture was stirred under heating with a hot stirrer at a reaction temperature of 150°C for 10 minutes. After completion of the reaction, the resultant was allowed to cool for 30 minutes and then transferred to a small test tube, and centrifuged at 4000 rpm for 5 minutes to separate a supernatant solution and a precipitate.

Thereafter, a dispersion liquid of the AgAuS ternary compound nanoparticle was obtained with centrifugation and purification performed in the same manner as in Example 1, etc.

[TEM observation and average particle size measurement]

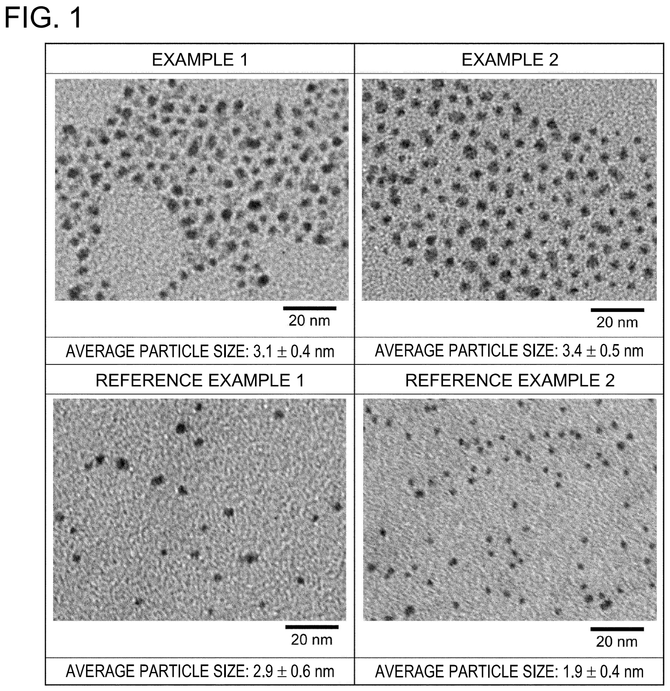

Each of the nanoparticles in Example 1 and Example 2 (AgAuSeIn) as well as Reference Example 1 (AgAuSe) and Reference Example 2 (AgAuS) was observed with TEM. Fig. 1 illustrates TEM images of the produced semiconductor nanoparticles (see scale bars in each of the images, with respect to the magnifications). It was confirmed from each of the TEM images that substantially spherical nanoparticles were synthesized. The average particle size with respect to the nanoparticles having respective compositions was measured and calculated based on the TEM images. Particle size measurement determined the particle sizes of all measurable nanoparticles included in the TEM images, and calculated the average particle size.

[Compositional analysis of nanoparticle]

Compositional analysis of each of the nanoparticles was carried out by the above TEM observation and also EDX analysis performed. Table 1 shows the measurement results of the compositions of the respective semiconductor nanoparticles. The compositional analysis results are expressed with "% by atom" relative to the entire nanoparticle in the present Embodiment and each Embodiment below. Table 1 also shows the ratio ($x/(x + y)$) of the number ($x$) of Ag atoms based on the total of the number ($x$) of Ag atoms and the number ($y$) of Au atoms, as calculated based on the compositional analysis results.

[Table 1]

| | Constitution of nanoparticle | Composition (% by atom) | | | | | x/(x+y) |
| --- | --- | --- | --- | --- | --- | --- | --- |
| | | Ag | Au | Se | S | In | |
| Example 1 | AgAuSeIn | 49.0 | 14.4 | 32.1 | - | 4.5 | 0.77 |
| Example 2 | | 35.6 | 10.3 | 16.2 | 26.7 | 11.2 | 0.78 |
| Reference Example 1 | AgAuSe | 57.8 | 17.4 | 24.8 | - | - | 0.77 |
| Reference Example 2 | AgAuS | 47.8 | 12.3 | - | 39.9 | - | 0.80 |
| * Total content of Ag, Au, chalcogen elements (Se, S), and In in compound constituting nanoparticle was 100%. | | | | | | | |

[Measurement of absorption spectrum and emission spectrum]

Next, an absorption spectrum was measured with respect to each of the semiconductor nanoparticles in Examples 1 and 2 and Reference Examples 1 and 2. The absorption spectrum was measured in a wavelength range of 400 nm to 1100 nm with an ultraviolet visible spectrophotometer (manufactured by Agilent Technologies, Agilent 8453).

An emission spectrum and an emission quantum efficiency were measured with respect to each of the nanoparticles. The emission spectrum was measured with a diode array spectrophotometer (PMA-12, C10027-02) manufactured by Hamamatsu Photonics K.K. The measurement was performed with a sample adjusted so that the absorbance at 365 nm in a chloroform solution (n = 1.4429) was 0.1.

The emission quantum yield was measured in a wavelength region of 900 nm or less with an absolute PL quantum yield measurement apparatus (manufactured by Hamamatsu Photonics K.K., C9920-03). When emission was observed at a long wavelength of 1000 nm or more, the emission spectrum was measured with a multichannel spectrophotometer (manufactured by Hamamatsu Photonics K.K., PMA-12 (Model No.: C10027-02 (wavelength range 350 to 1100 nm) and 10028-01 (wavelength range 900 to 1650 nm)). The measurement was performed with a sample adjusted so that the absorbance at 700 nm in a chloroform solution (n = 1.4429) was 0.1. The measurement was made at a wavelength of excitation light of 700 nm. The emission quantum yield in the near-infrared region was determined with measurement of an emission spectrum in an ethanol solution (n = 1.3618) of indocyanine green (ICG: $\phi$ = 13.2%) being an organic fluorescent dye emitting near-infrared light as a standard specimen, as an emission spectrum measured with a fluorescence spectrophotometer, and calculation of the emission quantum yield of each sample by a relative method with the following expression.

[Expression 1]

$$\Phi_{\mathrm{x}} = \Phi_{\mathrm{st}} \times \left(\frac{FA_{\mathrm{x}}}{FA_{\mathrm{st}}}\right) \times \left(\frac{A_{\mathrm{st}}}{A_{\mathrm{x}}}\right) \times \left(\frac{I_{\mathrm{ex,\ st}}}{I_{\mathrm{ex,\ x}}}\right) \times \left(\frac{n_{\mathrm{x}}^{2}}{n_{\mathrm{st}}^{2}}\right)$$

(A: Absorbance of specimen at excitation wavelength, Iex: Intensity of excitation light at excitation wavelength, n: Refractive index of solvent)

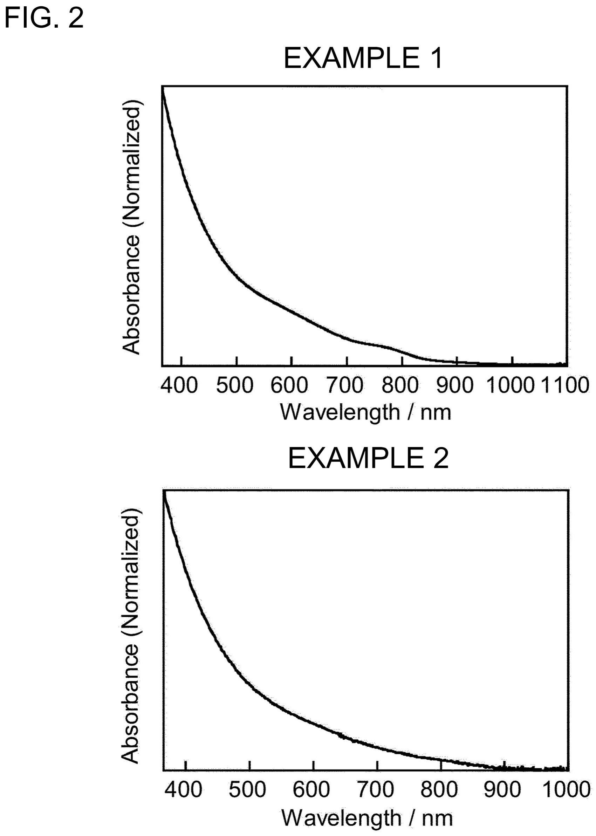

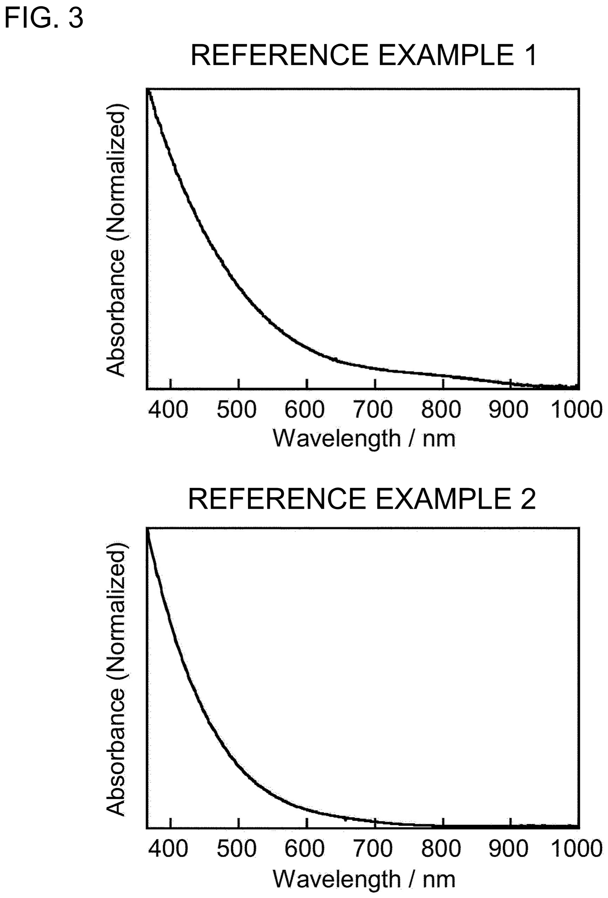

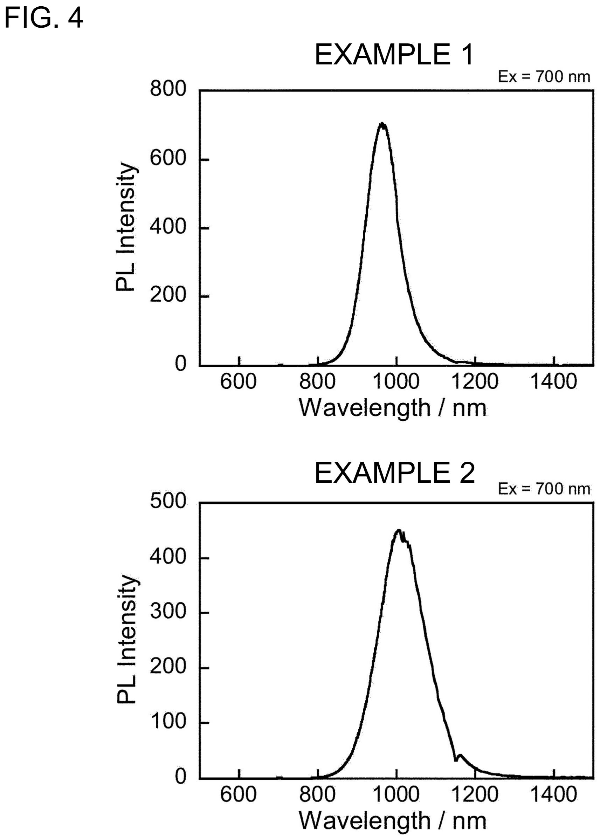

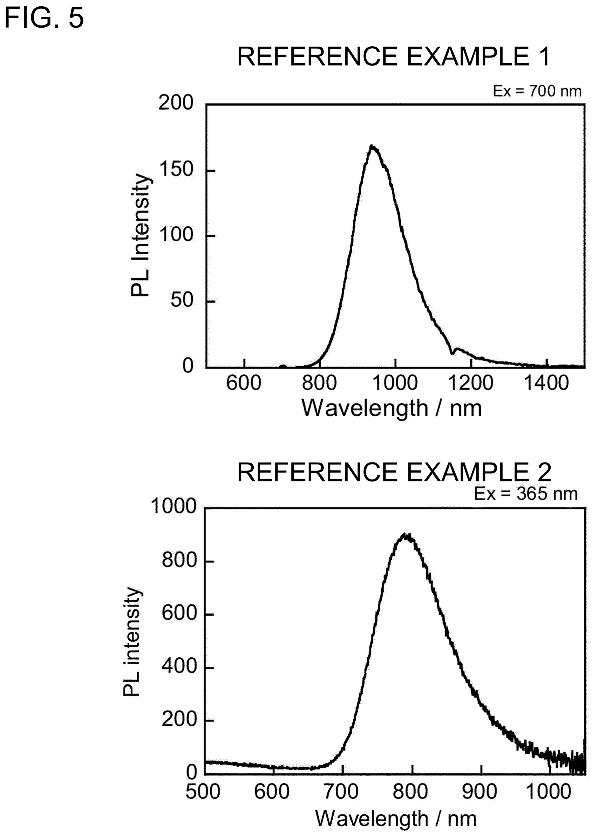

Fig. 2 and Fig. 3 illustrate the measurement results of an absorption spectrum of each of the semiconductor nanoparticles produced in the present Embodiment. Fig. 4 and Fig. 5 illustrate the measurement results of an emission spectrum of such each semiconductor nanoparticle. Table 2 summarizes and shows a relationship between the emission wavelength and the emission quantum yield of each of the semiconductor nanoparticles.

[Table 2]

| | Constitution of nanoparticle | Composition (% by atom) | | | | | x/(x+y) | Emission spectrum | |
|---|---|---|---|---|---|---|---|---|---|
| | | Ag | Au | Se | S | In | | λ (nm) | PLQY (%) |
| Example 1 | AgAuSeIn | 49.0 | 14.4 | 32.1 | - | 4.5 | 0.77 | 984 | 47.8 |
| Example 2 | | 35.6 | 10.3 | 16.2 | 26.7 | 11.2 | 0.78 | 1007 | 34.5 |
| Reference Example 1 | AgAuSe | 57.8 | 17.4 | 24.8 | - | - | 0.77 | 940 | 26.0 |
| Reference Example 2 | AgAuS | 47.8 | 12.3 | - | 39.9 | - | 0.80 | 778 | 4.2 |

Referring to Fig. 3, the absorption edge wavelength is 900 nm or more in Examples 1 and 2 (AgAuSeIn) and Reference Example 1 (AgAuSe) where the chalcogen element is Se. These semiconductor nanoparticles have an absorption edge wavelength longer than that in Reference Example 2 (AgAuS) where the chalcogen element is S. It can be seen that the optical responsivity in a long-wavelength region enhances with Se as the chalcogen element.

Referring to Fig. 4, the AgAuSeIn nanoparticles of Examples 1 and 2, where AgAuSe was doped with In, each exhibited an emission peak at substantially the same position (about 980 to 1000 nm) as in the nanoparticle (AgAuSe, Fig. 5) of Reference Example 1, and furthermore exhibited an emission peak at a position on the long-wavelength side as compared with an emission peak (about 780 nm) in Reference Example 2 (AgAuS, Fig. 5). It is confirmed from these results that Se as an essential chalcogen element can be applied to allow optical response characteristics in a long-wavelength region to be exhibited.

It is then confirmed from comparison of Examples 1 and 2 with Reference Example 1 that an increase in emission quantum efficiency is exerted as the effect of doping of the AgAuS-based compound with In (metal M). In particular, the AgAuSeIn nanoparticle of Example 1, synthesized with direct synthesis, exhibited an extremely favorable quantum efficiency. It was confirmed from the above results in the present Embodiment that doping with In (metal M), with, as a base, a AgAuSe-based compound with a chalcogen element essentially including Se, was preferable for formation of a suitable semiconductor nanoparticle and thus not only response to a long-wavelength region, but also excellent emission characteristics were exhibited.

Second Embodiment: In the present Embodiment, the change of characteristics due to the amount of doping with

In in a AgAuSeIn nanoparticle was studied with reference to suitable results in the AgAuSeIn nanoparticle of First Embodiment.

A AgAuSeIn nanoparticle in the present Embodiment was synthesized basically according to Example 1 (direct synthesis) of First Embodiment. Specifically, a test tube was loaded with indium acetate as an In precursor and selenourea together with 0.075 mmol of silver acetate and 0.025 mmol of chloro(dimethylsulfide)gold(I), and 2.9 mL of a solvent (oleylamine) and 0.1 mL of a protective agent (1-dodecanethiol) were added to the mixture, to synthesize AgAuSeIn nanoparticles. The reaction conditions were set so that the heating temperature was 50°C, the reaction time was 10 minutes, and the treatment before and after the reaction was the same as in Example 1.

In the present Embodiment, the amount (0.1 mmol) of In loaded in Example 1 was assumed to be "1 time" as reference, and In in an amount 0.5 times, 0.75 times, 0.88 times, 1.25 times, 1.5 times, 2 times, or 4 times the above amount loaded was added to the reaction system. The positive charges of Ag, Au, and In were considered from the amount of In added in each sample, and the amount of Se (selenourea) added was adjusted so that the negative charges were equal to the positive charges.

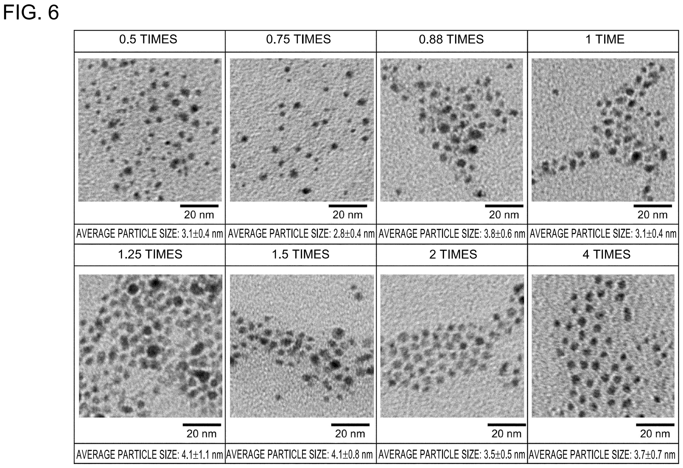

The AgAuSeIn nanoparticle synthesized in each amount of doping with In was subjected to TEM observation and compositional analysis in the same manner as in First Embodiment. Fig. 6 illustrates TEM photographs of the AgAuSeIn nanoparticles in respective amounts of doping with In (amounts loaded: 0.5 times, 0.75 times, 0.88 times, 1 time, 1.25 times, 1.5 times, 2 times, and 4 times). Table 3 shows the compositional analysis results of these semiconductor nanoparticles.

[Table 3]

| Amount of In loaded | Amount loaded (mmol) | | Composition (% by atom) | | | | x/(x+y) |
|---|---|---|---|---|---|---|---|
| | In (OAc) | SeC (NH$_2$)$_2$ | Ag | Au | Se | In | |
| 0.5 times | 0.050 | 0.125 | 60.3 | 8.1 | 27.0 | 4.6 | 0.88 |
| 0.75 times | 0.075 | 0.163 | 58.6 | 9.9 | 28.3 | 3.2 | 0.86 |
| 0.88 times | 0.880 | 0.182 | 51.0 | 11.4 | 32.0 | 5.6 | 0.82 |
| 1 time | 0.100 | 0.200 | 47.6 | 17.5 | 30.8 | 4.1 | 0.73 |
| 1.25 times | 0.125 | 0.238 | 46.9 | 14.0 | 33.8 | 5.3 | 0.77 |
| 1.5 times | 0.150 | 0.275 | 40.8 | 10.1 | 30.5 | 18.6 | 0.80 |
| 2 times | 0.200 | 0.350 | 38.1 | 11.0 | 38.1 | 12.8 | 0.78 |
| 4 times | 0.400 | 0.450 | 20.0 | 4.1 | 42.2 | 33.7 | 0.83 |

* Amount of In loaded in Example 1 of First Embodiment is assumed to be "1 time"
* Total content of Ag, Au, Se, and In in compound constituting nanoparticle was 100%.

From Table 3, the contents of In in the AgAuSeIn nanoparticles do not largely differ among 0.5 times to 1.25 times the amount of In loaded when the amount of In loaded is varied. The content of In largely increases with an amount of In loaded of 1.5 times or more.

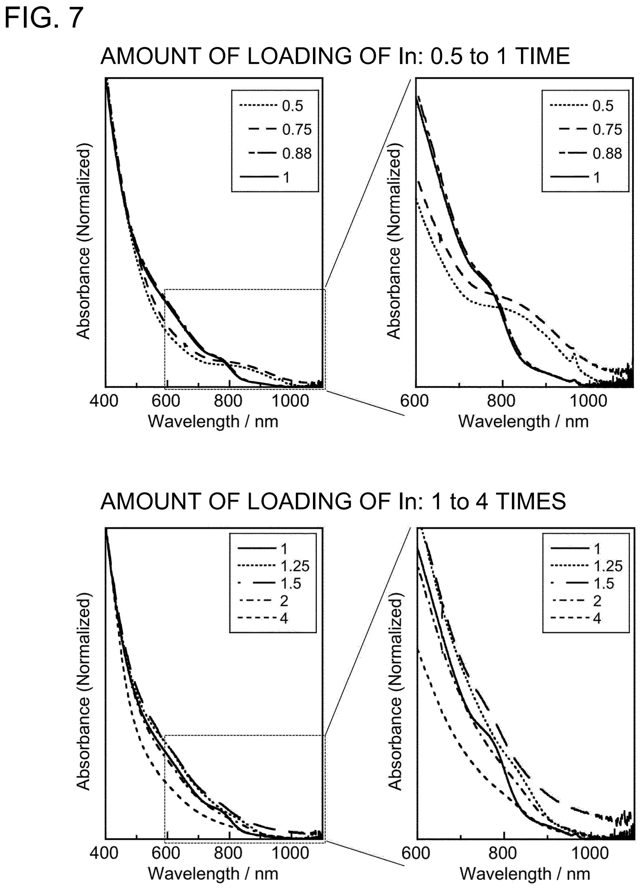

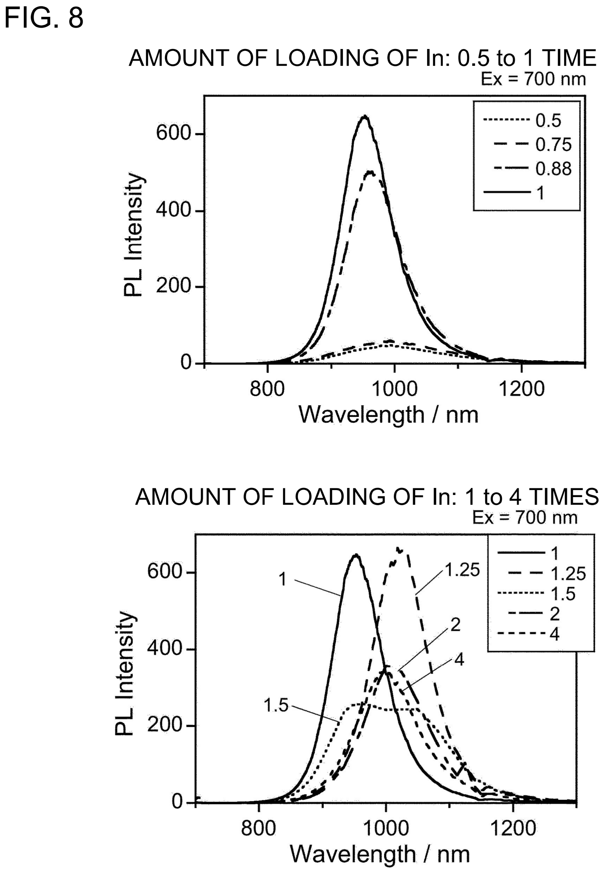

The AgAuSeIn nanoparticle synthesized in the present Embodiment was measured with respect to an absorption spectrum as well as an emission spectrum and an emission quantum efficiency by the same methods as in First Embodiment. Fig. 7 illustrates the measurement results of the absorption spectra and Fig. 8 illustrates the measurement results of the emission spectra with respect to the semiconductor nanoparticles produced in the present Embodiment (amounts of In loaded: 0.5 times, 0.75 times, 0.88 times, 1 time, 1.25 times, 1.5 times, 2 times, and 4 times). Table 4 summarizes and shows peak wavelengths of the emission spectra, and the measurement values of the emission quantum efficiencies.

[Table 4]

| Amount of In loaded | Composition (% by atom) | | | | x/(x+y) | Emission spectrum | |
|---|---|---|---|---|---|---|---|
| | Ag | Au | Se | In | | λ (nm) | PLQY (%) |
| 0.5 times | 60.3 | 8.1 | 27.0 | 4.6 | 0.88 | 985 | 8.3 |
| 0.75 times | 58.6 | 9.9 | 28.3 | 3.2 | 0.86 | 989 | 11.5 |
| 0.88 times | 51.0 | 11.4 | 32.0 | 5.6 | 0.82 | 961 | 50.1 |

(continued)

| Amount of In loaded | Composition (% by atom) | | | | x/(x+y) | Emission spectrum | |
|---|---|---|---|---|---|---|---|
| | Ag | Au | Se | In | | λ (nm) | PLQY (%) |
| 1 time | 47.6 | 17.5 | 30.8 | 4.1 | 0.73 | 984 | 47.8 |
| 1.25 times | 46.9 | 14.0 | 33.8 | 5.3 | 0.77 | 1024 | 52.9 |
| 1.5 times | 40.8 | 10.1 | 30.5 | 18.6 | 0.80 | 957/1031 | 54.1 |
| 2 times | 38.1 | 11.0 | 38.1 | 12.8 | 0.78 | 1010 | 33.1 |
| 4 times | 20.0 | 4.1 | 42.2 | 33.7 | 0.83 | 992 | 31.9 |
| * Amount of In loaded in Example 1 of First Embodiment is assumed to be "1 time" | | | | | | | |

Referring to the absorption spectrum curves in Fig. 7, the AgAuSeIn nanoparticles with amounts of In loaded of 0.5 times and 0.75 times exhibit similar curves, and are considered to exhibit small peaks possibly regarded as exciton peaks around 850 nm and have absorption edges around 1040 nm. The AgAuSeIn nanoparticles with amounts of In loaded of 0.88 times and 1 time exhibit substantially overlapped curves, and exhibit small peaks possibly regarded as exciton peaks around 780 nm and have absorption edges around 850 nm and around 1000 nm. The AgAuSeIn nanoparticles with amounts of In loaded of 1.25 times or more exhibit no small peaks possibly regarded as exciton peaks, and exhibit absorption edges around 1040 nm.

Next, the measurement results of the emission spectra in Fig. 8 and Table 4 are reviewed. The AgAuSeIn nanoparticles produced in the present Embodiment not only have emission peaks in a long-wavelength region, but also exhibit high quantum yields as compared with the AgAuS nanoparticles of Reference Example 2 of First Embodiment. In particular, the AgAuSeIn nanoparticles with amounts of In loaded of 0.88 times to 1.5 times each exhibit a high quantum yield of 40% or more.

The peak wavelengths of the emission spectra are classified based on the amount of In loaded. The AgAuSeIn nanoparticles with amounts of In loaded of 0.5 times and 0.75 times each exhibited a low-intensity emission peak wavelength around 985 nm. When the amounts of In loaded were 0.88 times and 1 time, the emission intensity highly increased and the peak wavelength was exhibited around 960 to 980 nm. When the amount of In loaded was 1.25 times or more, the emission peak wavelength shifted toward a long-wavelength around 1000 nm. This is the same as the viewpoint where the shapes of the absorption spectra are classified based on the amount of In loaded.

Third Embodiment: In the present Embodiment, AgAuSeIn nanoparticles of various compositions were each synthesized at the ratio between the amounts of the Ag precursor loaded and that of the Au precursor, as adjusted in AgAuSeIn nanoparticle synthesis, and characteristics of the nanoparticles were studied.

A AgAuSeIn nanoparticle synthesis method in the present Embodiment was basically according to Example 1 (direct synthesis) of First Embodiment. A test tube was loaded with 0.1 mmol in total of silver acetate and chloro(dimethylsulfide)gold(I), 0.1 mmol of indium acetate, and 0.2 mmol of selenourea, and 2.9 mL of a solvent (oleylamine) and 0.1 mL of a protective agent (1-dodecanethiol) were added to the mixture, and heated to synthesize a AgAuSeIn nanoparticle.

In the present Embodiment, each AgAuSeIn nanoparticle was synthesized with the amounts of the Ag precursor (silver acetate) and the Au precursor (chloro(dimethylsulfide)gold(I)) loaded set so that the ratio (a/(a + b)) of the amount of Ag loaded based on the total of the number (a) of Ag atoms in the Ag precursor and the number (b) of Au atoms in the Au precursor was 0, 0.25, 0.5, 0.75, 0.82, 0.88, 0.94, or 1.0. A reaction system at such a ratio of the amount loaded was set with a heating temperature of 50°C and a reaction time of 20 minutes, to synthesize each AgAuSeIn nanoparticle. A reaction system at a ratio of the amount of Ag loaded of 0.25, 0.5, 0.75, or 0.88 was set with a heating temperature of 50°C and a reaction time of 10 minutes, to synthesize each AgAuSeIn nanoparticle, in addition to the above nanoparticles.

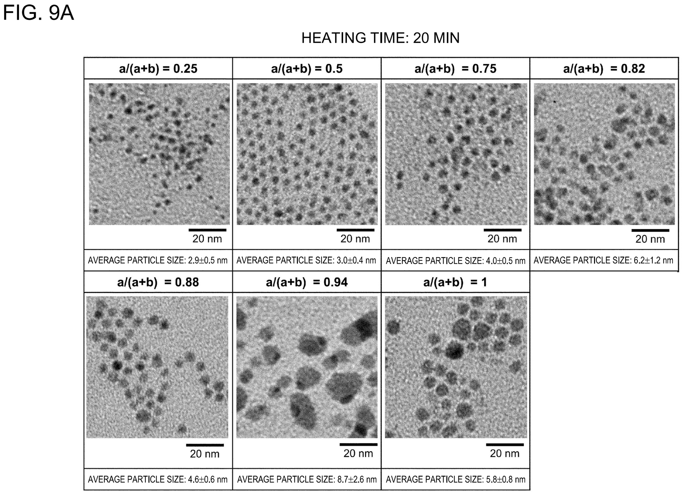

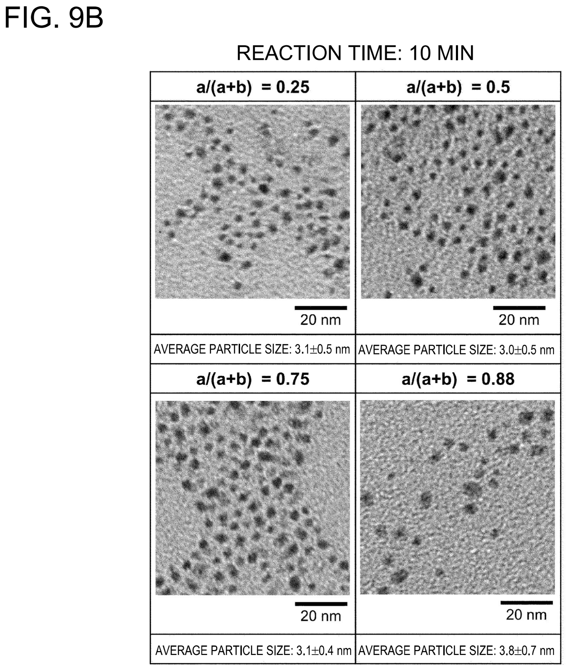

The AgAuSeIn nanoparticles synthesized at the ratio of Ag loaded adjusted in the present Embodiment were subjected to TEM observation and compositional analysis in the same manner as in First Embodiment. Fig. 9a illustrates TEM photographs of the AgAuSeIn nanoparticles synthesized at ratios of Ag loaded of 0, 0.25, 0.5, 0.75, 0.82, 0.88, 0.94, and 1.0 for a heating time of 20 minutes. Fig. 9b illustrates TEM photographs of the AgAuSeIn nanoparticles synthesized at ratios of Ag loaded of 0.25, 0.5, 0.75, and 0.88 for a heating time of 10 minutes. Table 5 shows the compositional analysis results of these semiconductor nanoparticles.

[Table 5]

| a/(a+b) | Amount loaded (mmol) | | Reaction time | Composition (% by atom) | | | | x/(x+y) |
|---|---|---|---|---|---|---|---|---|
| | Ag (OAc) | (Me)$_2$SAuCl | | Ag | Au | Se | In | |
| 0 | 0 | 1.0 | 20 min | 0.0 | 33.4 | 44.4 | 22.2 | 0.00 |
| 0.25 | 0.025 | 0.075 | 10 min | 31.6 | 29.1 | 32.4 | 6.9 | 0.52 |
| | | | 20 min | 26.1 | 29.8 | 35.9 | 8.2 | 0.47 |
| 0.5 | 0.05 | 0.05 | 10 min | 36.7 | 23.7 | 33.8 | 5.8 | 0.61 |
| | | | 20 min | 35.3 | 28.3 | 32.2 | 4.2 | 0.56 |
| 0.75 | 0.075 | 0.025 | 10 min | 47.6 | 17.5 | 30.8 | 4.1 | 0.73 |
| | | | 20 min | 46.5 | 15.7 | 33.3 | 4.5 | 0.75 |
| 0.82 | 0.082 | 0.018 | 20 min | 47.2 | 10.4 | 36.0 | 6.4 | 0.82 |
| 0.88 | 0.088 | 0.013 | 10 min | 35.4 | 6.8 | 36.4 | 21.4 | 0.84 |
| | | | 20 min | 50.8 | 6.9 | 35.8 | 6.5 | 0.88 |
| 0.94 | 0.094 | 0.006 | 20 min | 55.0 | 2.8 | 35.9 | 6.3 | 0.95 |
| 1.0 | 1.0 | 0 | 20 min | 55.3 | 0.0 | 37.4 | 7.3 | 1.00 |
| * Total content of Ag, Au, Se, and In in compound constituting nanoparticle was 100%. | | | | | | | | |

It is confirmed from Table 5 that the ratio of Ag loaded is adjusted to change the content of Ag in each of the AgAuSeIn nanoparticles. In other words, the ratio (x/(x + y)) of the number of Ag atoms based on the total of the number (x) of Ag atoms and the number (y) of Au atoms in the AgAuSeIn compound constituting each of the AgAuSeIn nanoparticles increases with an increase in ratio of Ag loaded.

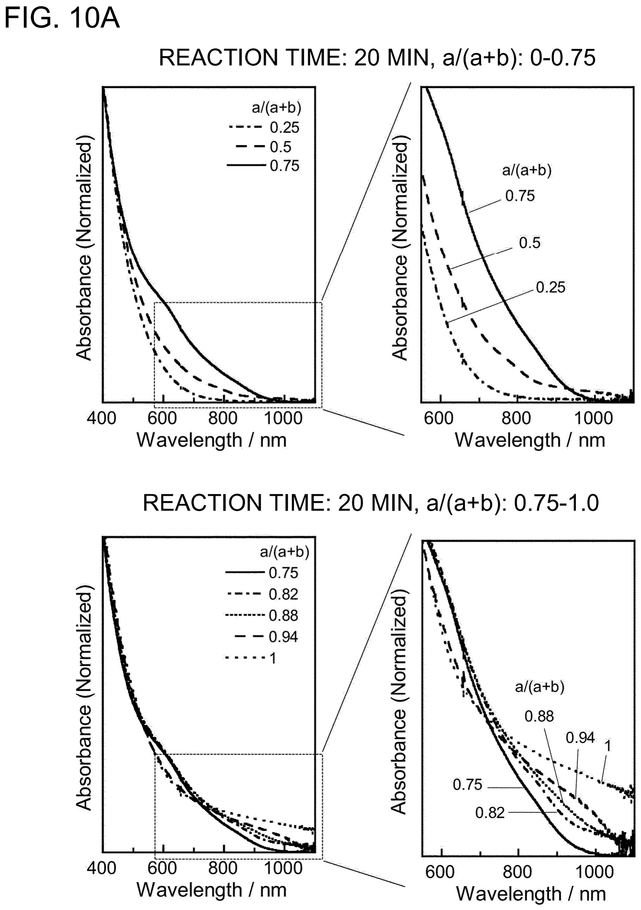

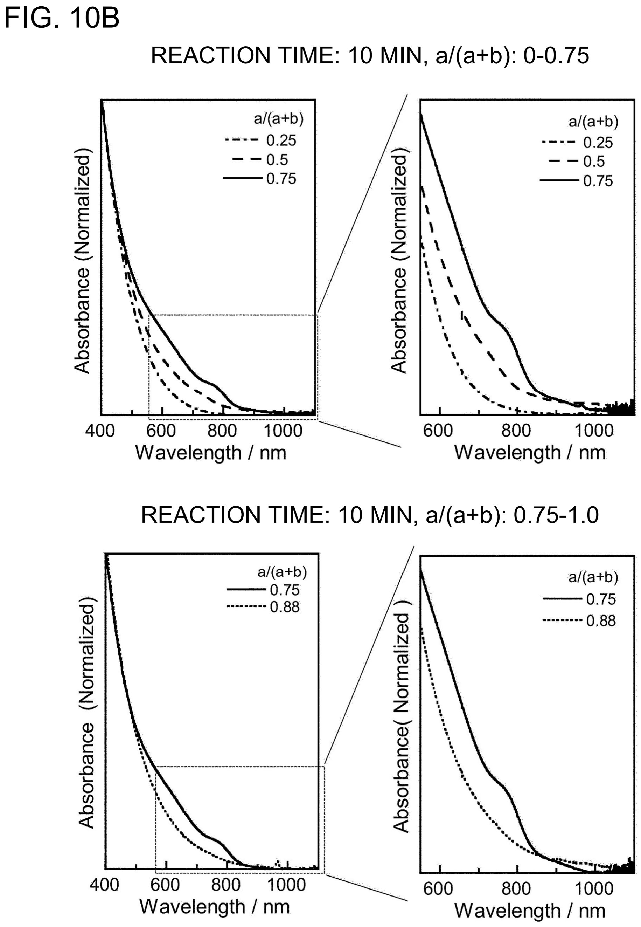

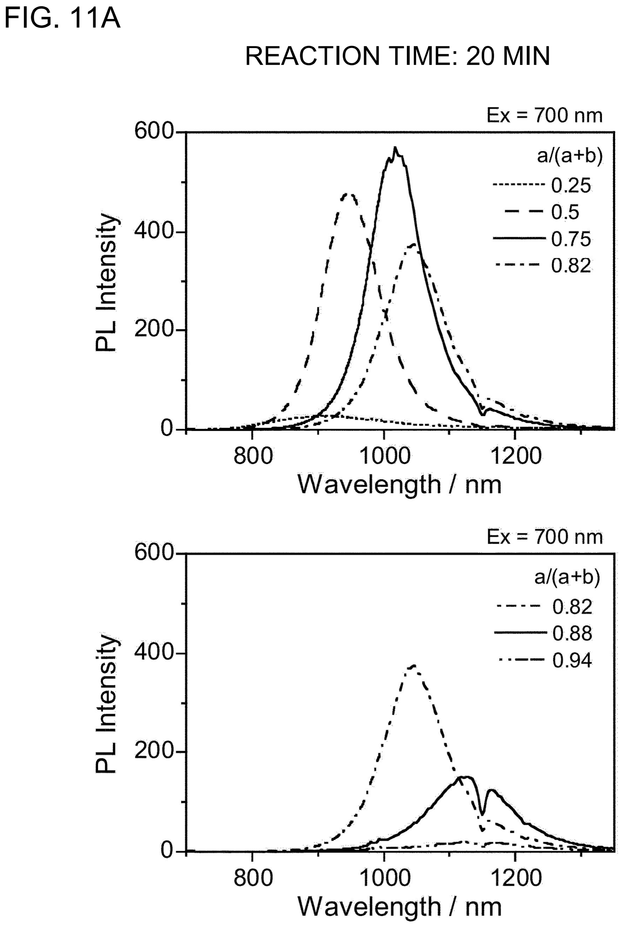

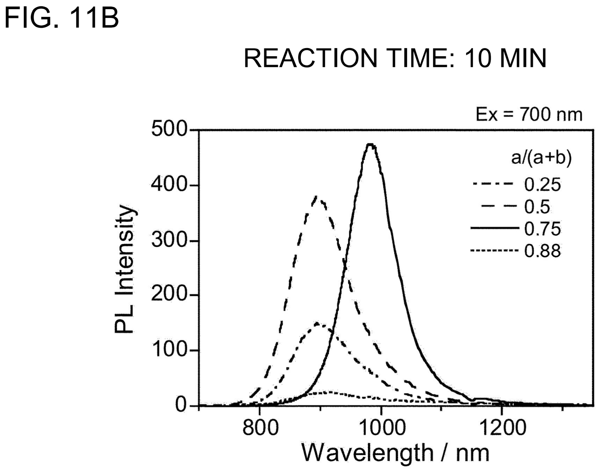

Each of the AgAuSeIn nanoparticles was measured with respect to an absorption spectrum as well as an emission spectrum and an emission quantum efficiency. The measurement methods and conditions of these nanoparticles were basically the same as in First Embodiment, but a sample having a ratio of Ag loaded of 0.25 in the emission spectrum measurement had an absorption edge at about 700 nm and did not allow light excitation to occur with excitation light at a wavelength of 700 nm and thus only this sample was measured at an excitation wavelength of 365 nm. Fig. 10a and Fig. 10b illustrate the measurement results of the absorption spectra and Fig. 11a and Fig. 11b illustrate the measurement results of the emission spectra with respect to the semiconductor nanoparticles produced in the present Embodiment. Table 6 summarizes and shows peak wavelengths of the emission spectra, and the measurement values of the emission quantum efficiencies.

[Table 6]

| a/ (a+b) | Reaction time | Composition (% by atom) | | | | x/(x+y) | Emission spectrum | |
|---|---|---|---|---|---|---|---|---|
| | | Ag | Au | Se | In | | λ (nm) | PLQY (%) |
| 0 | 20 min | 0.0 | 33.4 | 44.4 | 22.2 | 0.00 | - | 0.0 |
| 0.25 | 10 min | 31.6 | 29.1 | 32.4 | 6.9 | 0.52 | 900 | 20.0 |
| | 20 min | 26.1 | 29.8 | 35.9 | 8.2 | 0.47 | 911 | 10.0 |
| 0.5 | 10 min | 36.7 | 23.7 | 33.8 | 5.8 | 0.61 | 890 | 43.7 |
| | 20 min | 35.3 | 28.3 | 32.2 | 4.3 | 0.56 | 943 | 48.7 |
| 0.75 | 10 min | 47.6 | 17.5 | 30.8 | 4.2 | 0.73 | 984 | 47.8 |
| | 20 min | 46.5 | 15.7 | 33.3 | 4.5 | 0.75 | 1018 | 53.5 |
| 0.82 | 20 min | 47.2 | 10.4 | 36.0 | 6.5 | 1 0.82 | 1046 | 42.2 |
| 0.88 | 10 min | 35.4 | 6.8 | 36.4 | 21.4 | 0.84 | 908 | 9.2 |
| | 20 min | 50.8 | 6.9 | 35.8 | 6.5 | 0.88 | 1130 | 21.9 |
| 0.94 | 20 min | 55.0 | 1 2.8 | 35.9 | 6.3 | 0.95 | 1150 | 4.3 |

(continued)

| a/ (a+b) | Reaction time | Composition (% by atom) | | | | x/(x+y) | Emission spectrum | |
|---|---|---|---|---|---|---|---|---|
| | | Ag | Au | Se | In | | λ (nm) | PLQY (%) |
| 1.0 | 20 min | 55.3 | 0.0 | 37.4 | 7.3 | 1.00 | - | 0.01 |

Referring to the absorption spectrum curves in Figs. 10a and 10b, an increase in ratio of Ag loaded basically is liable to provide a longer absorption edge wavelength. Referring to Fig. 10b, a AgAuSeIn nanoparticle having a ratio of Ag loaded of 0.75 exhibits the longest absorption edge wavelength and one having a ratio of Ag loaded of 0.88 exhibits a slightly short absorption edge wavelength, among AgAuSeIn nanoparticles produced for a reaction time of 10 minutes. On the contrary, referring to Fig. 10a, the reaction time is set to 20 minutes and thus a AgAuSeIn nanoparticle having a ratio of Ag loaded of 0.88 exhibits a longer absorption edge wavelength than one having a loading ratio of Ag of 0.75.

Next, referring to the measurement results and measurement values of the emission spectra in Figs. 11a and 11b and Table 6, the emission peak is liable to shift toward a longer wavelength with an increase in ratio of Ag loaded. The AgAuSeIn nanoparticles at ratios of Ag loaded of 0.5 and 0.75 each exhibited a particularly high emission quantum yield and also a narrow peak width. No emission was observed in the AgAuSeIn nanoparticles at ratios of Ag loaded of 0 and 1.0. In view of the reaction time, a AgAuSeIn nanoparticle synthesized with heating for 20 minutes generally has an emission peak on the longer wavelength side.

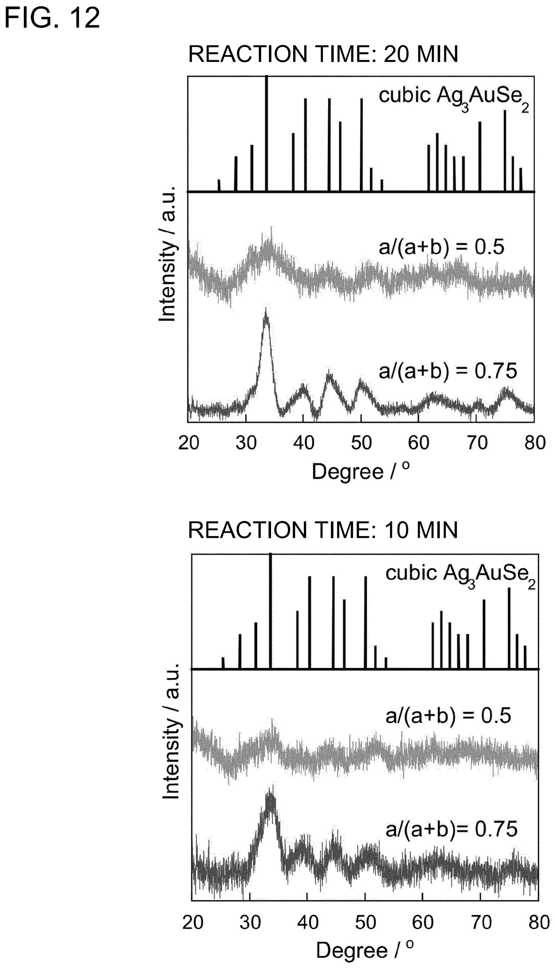

Fig. 12 illustrates the XRD analysis results with respect to the AgAuSeIn nanoparticles at ratios of Ag loaded of 0.5 and 0.75 (reaction times of 20 minutes and 10 minutes). The XRD analysis apparatus was Smart-Lab-3K manufactured by Rigaku Corporation, the characteristic X-ray was a CuK$\alpha$ ray, and the analysis condition included 1°/min. A diffraction peak assigned to $Ag_3AuSe_2$ is observed even in the AgAuSeIn nanoparticle synthesized at any ratio of Ag loaded and reaction time, from Fig. 12. Here, a AgAuSeIn nanoparticle at a ratio of Ag loaded of 0.75 is higher in crystallinity than one at a ratio of Ag loaded of 0.5. Such a AgAuSeIn nanoparticle at a ratio of Ag loaded of 0.75 exhibits a sharper peak and is further higher in crystallinity with a reaction time set to 20 minutes.

Fourth Embodiment: In the present Embodiment, AgAuSeIn nanoparticles were synthesized at a plurality of reaction times in order to study the reaction time in more detail. In the present Embodiment, a reaction system was formed in the same conditions as in Example 1 of First Embodiment (ratio of Ag loaded: 0.75, amount of In loaded: 1 time), and AgAuSeIn nanoparticles were synthesized at a reaction temperature of 50°C with reaction times set to 5 minutes, 10 minutes, 15 minutes, 20 minutes, 40 minutes, and 80 minutes.

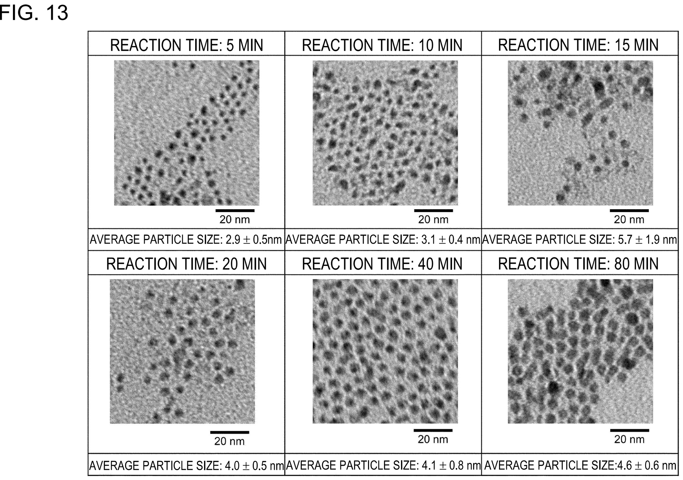

The AgAuSeIn nanoparticles synthesized in the reaction times adjusted in the present Embodiment were subjected to TEM observation and compositional analysis. Fig. 13 illustrates TEM photographs of such various AgAuSeIn nanoparticles (reaction times: 5 minutes, 10 minutes, 15 minutes, 20 minutes, 40 minutes, and 80 minutes). Table 7 shows the compositional analysis results of these semiconductor nanoparticles.

[Table 7]

| Reaction time | Composition (% by atom) | | | | x/(x+y) |
|---|---|---|---|---|---|
| | Ag | Au | Se | In | |
| 5 min | 52.0 | 12.4 | 30.2 | 5.4 | 0.81 |
| 10 min | 47.6 | 17.5 | 30.8 | 4.1 | 0.73 |
| 15 min | 48.0 | 17.9 | 30.8 | 3.3 | 0.73 |
| 20 min | 46.5 | 15.7 | 33.3 | 4.5 | 0.75 |
| 40 min | 43.7 | 15.7 | 35.3 | 5.3 | 0.74 |
| 80 min | 43.4 | 14.6 | 35.8 | 6.2 | 0.75 |
| * Total content of Ag, Au, Se, and In in compound constituting nanoparticle was 100%. | | | | | |

Referring to Table 7, the content of Ag is liable to decrease and the content of Se is liable to increase with an increase in reaction time. However, these amounts of change are slight and not dramatic. An increase in reaction time is considered not to have a too large effect on the AgAuSeIn nanoparticle composition.

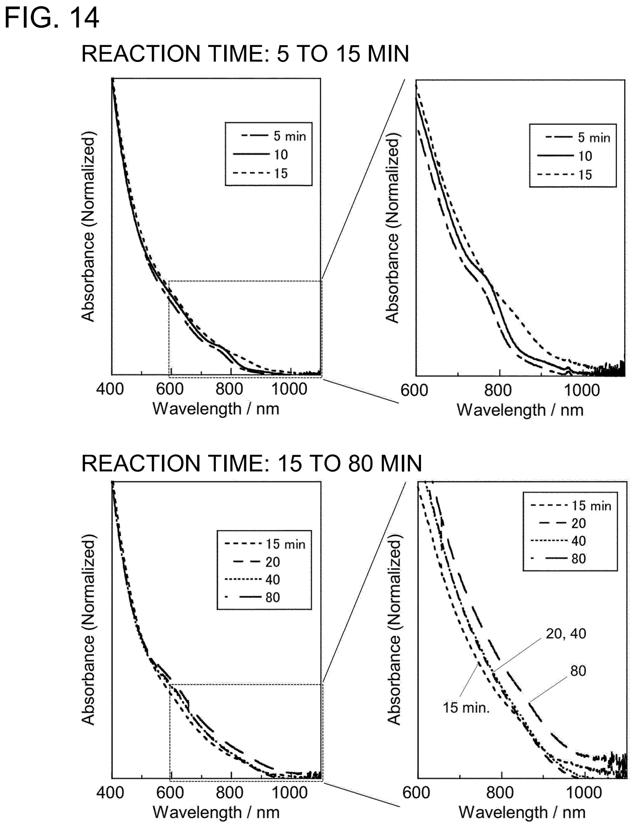

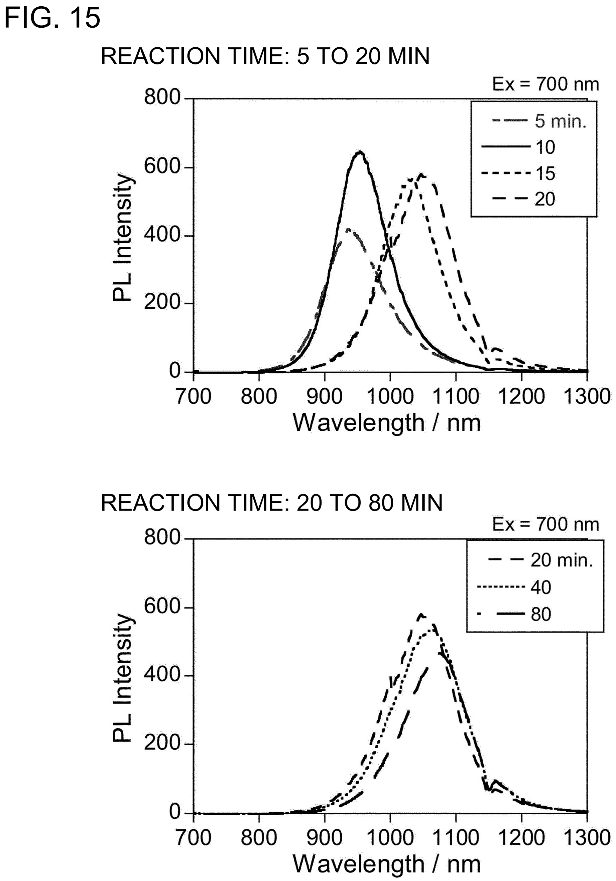

Each of the AgAuSeIn nanoparticles was measured with respect to an absorption spectrum as well as an emission spectrum and an emission quantum efficiency. The measurement methods and conditions of these nanoparticles are basically the same as in First Embodiment. Fig. 14 illustrates the measurement results of the absorption spectra and Fig. 15 illustrates the measurement results of the emission spectra with respect to the semiconductor nanoparticles produced in the present Embodiment (reaction times: 5 minutes, 10 minutes, 15 minutes, 20 minutes, 40 minutes, and 80 minutes). Table 8 summarizes and shows peak wavelengths of the emission spectra, and the emission quantum efficiencies.

[Table 8]

| Reaction time | Composition (% by atom) | | | | x/(x+y) | Emission spectrum | |
|---|---|---|---|---|---|---|---|
| | Ag | Au | Se | In | | λ (nm) | PLQY (%) |
| 5 min | 52.0 | 12.4 | 30.2 | 5.4 | 0.81 | 936 | 46.1 |
| 10 min | 47.6 | 17.5 | 30.8 | 4.2 | 0.73 | 984 | 47.8 |
| 15 min | 48.0 | 17.9 | 30.8 | 3.4 | 0.73 | 1028 | 41.9 |
| 20 min | 46.5 | 15.7 | 33.3 | 4.5 | 0.75 | 1018 | 53.5 |
| 40 min | 43.7 | 15.7 | 35.3 | 5.4 | 0.74 | 1059 | 56.7 |
| 80 min | 43.4 | 14.6 | 35.8 | 6.2 | 0.75 | 1070 | 48.3 |

Referring to the absorption spectrum curves in Fig. 14, it can be seen that the absorption edge is liable to shift toward a longer wavelength as the reaction times increases. Referring to enlarged diagrams of Fig. 14, the absorption spectra for reaction times of 5 minutes and 10 minutes slightly shift, but are similar in shape and have two absorption edges confirmed. The absorption spectrum shapes largely change at a reaction time of 15 minutes or more, and are substantially the same shapes at the subsequent reaction times.

Referring to the measurement results of the emission spectra in Fig. 15 and Table 8, all the AgAuSeIn nanoparticles synthesized for the reaction times adjusted, in the present Embodiment, each exhibit a high emission quantum yield of 40% or more. However, with respect to emission peak wavelengths, it is deemed that a reaction time of 10 minutes or less, for which a peak at less than 1000 nm is found, and a reaction time of 15 minutes or more, for which a peak at 1000 nm or more is found, are grouped.

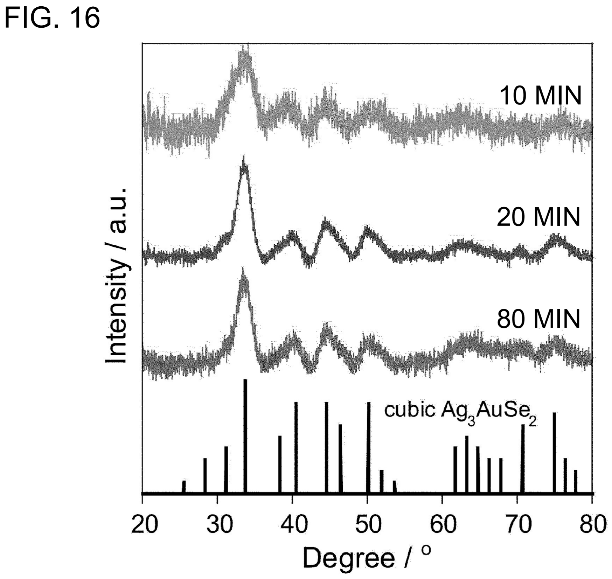

Fig. 16 illustrates the XRD analysis results with respect to the AgAuSeIn nanoparticles synthesized for reaction times of 10 minutes, 20 minutes, and 80 minutes. As described with respect to the study results in Third Embodiment, the reaction time is set to 20 minutes to provide a sharp diffraction peak and enhanced crystallinity observed. However, such crystallinity with an increase in reaction time less changes even with an excessively elongated time. The reason is because the diffraction peak at a reaction time of 80 minutes almost does not differ from that of 20 minutes. In consideration of grouping of the measurement results of the emission peak wavelengths in Table 8, some change in AgAuSeIn nanoparticle structure is predicted to occur at a stage of a reaction time of 10 minutes to 15 minutes. This change in structure is not limited to simple crystallization and is assumed to be the change with an element distribution in the nanoparticle, for example, formation of the nanoparticle into a core-shell structure, but the detail is not clear.

INDUSTRIAL APPLICABILITY

As described above, a novel semiconductor nanoparticle including a AgAuSe-based multinary compound of the present invention can exhibit favorable optical semiconductor characteristics. The AgAuSe-based multinary compound is a low-toxic compound having biocompatibility. Thus, the semiconductor nanoparticle of the present invention is expected to be applied in a light-emitting device utilized in a display apparatus, a marker substance for bio-related substance detection, or the like, a fluorescent substance, or a photoelectric conversion device or a light-receiving device mounted in a solar battery, a light sensor, or the like.

The semiconductor nanoparticle of the present invention has improved emission and light absorption characeristics in a long-wavelength region including the near infrared region (NIR) and the short-wave infrared region (SWIR). The present invention is thus particularly useful for a light-receiving device applicable in LIDAR and SWIR image sensors where responsivity in the near-infrared region is important, among photonic devices described above.

**Claims**

1.   A semiconductor nanoparticle comprising a compound containing Ag, Au, a chalcogen element essentially including Se, and a metal M, as essential constituent elements, wherein

the metal M is at least any one of Al, Ga, In, Tl, Zn, Cd, Hg, and Cu, and

a total content of Ag, Au, the chalcogen element essentially including Se, and the metal M in the compound is 95% by mass or more.

2. The semiconductor nanoparticle according to claim 1, wherein a content of the metal M in the compound is 1% by atom or more and 50% by atom or less.

3. The semiconductor nanoparticle according to claim 1 or claim 2, wherein a ratio $(x/(x + y))$ of the number of Ag atoms based on a total of the number $x$ of Ag atoms and the number $y$ of Au atoms in the compound is 0.20 or more and 0.95 or less.

4. The semiconductor nanoparticle according to claim 1 or claim 2, wherein a content of the chalcogen element essentially including Se in the compound is 25% by atom or more and 60% by atom or less.

5. The semiconductor nanoparticle according to claim 3, wherein a content of the chalcogen element essentially including Se in the compound is 25% by atom or more and 60% by atom or less.

6. The semiconductor nanoparticle according to claim 1 or claim 2, wherein the compound is a compound containing Ag, Au, and Se, doped with the metal M.

7. The semiconductor nanoparticle according to claim 1 or claim 2, wherein the compound comprises:

   a core compound containing Ag, Au, and Se; and
   a shell compound that covers at least a part of a surface of the core compound and that is the metal M and/or essentially contains the metal M and contains at least any one of Ag, Au and Se.

8. The semiconductor nanoparticle according to claim 1 or claim 2, wherein an average particle size is 2 nm or more and 20 nm or less.

9. The semiconductor nanoparticle according to claim 1 or claim 2, wherein at least any one of an alkylamine having 4 or more and 20 or less alkyl chain carbon atoms, an alkenylamine having 4 or more and 20 or less alkenyl chain carbon atoms, an alkylcarboxylic acid having 3 or more and 20 or less alkyl chain carbon atoms, an alkenylcarboxylic acid having 3 or more and 20 or less alkenyl chain carbon atoms, an alkanethiol having 4 or more and 20 or less alkyl chain carbon atoms, a trialkylphosphine having 4 or more and 20 or less alkyl chain carbon atoms, a trialkylphosphine oxide having 4 or more and 20 or less alkyl chain carbon atoms, triphenylphosphine, and triphenylphosphine oxide is bound as a protective agent to a surface of the semiconductor nanoparticle.

10. The semiconductor nanoparticle according to claim 1 or claim 2, wherein an absorption edge wavelength on a long-wavelength side of an absorption spectrum is 800 nm or more.

FIG. 1

| EXAMPLE 1 | EXAMPLE 2 |
|---|---|
| | |
| AVERAGE PARTICLE SIZE: 3.1 ± 0.4 nm | AVERAGE PARTICLE SIZE: 3.4 ± 0.5 nm |
| REFERENCE EXAMPLE 1 | REFERENCE EXAMPLE 2 |
| | |
| AVERAGE PARTICLE SIZE: 2.9 ± 0.6 nm | AVERAGE PARTICLE SIZE: 1.9 ± 0.4 nm |

FIG. 2

EXAMPLE 1

EXAMPLE 2

FIG. 3

## REFERENCE EXAMPLE 1

## REFERENCE EXAMPLE 2

EP 4 656 595 A1

FIG. 4

EXAMPLE 1

Ex = 700 nm

EXAMPLE 2

Ex = 700 nm

FIG. 5

REFERENCE EXAMPLE 1

Ex = 700 nm

REFERENCE EXAMPLE 2

Ex = 365 nm

FIG. 6

| 0.5 TIMES | 0.75 TIMES | 0.88 TIMES | 1 TIME |
|---|---|---|---|
| 20 nm | 20 nm | 20 nm | 20 nm |
| AVERAGE PARTICLE SIZE: 3.1±0.4 nm | AVERAGE PARTICLE SIZE: 2.8±0.4 nm | AVERAGE PARTICLE SIZE: 3.8±0.6 nm | AVERAGE PARTICLE SIZE: 3.1±0.4 nm |
| 1.25 TIMES | 1.5 TIMES | 2 TIMES | 4 TIMES |
| 20 nm | 20 nm | 20 nm | 20 nm |
| AVERAGE PARTICLE SIZE: 4.1±1.1 nm | AVERAGE PARTICLE SIZE: 4.1±0.8 nm | AVERAGE PARTICLE SIZE: 3.5±0.5 nm | AVERAGE PARTICLE SIZE: 3.7±0.7 nm |

## FIG. 7

### AMOUNT OF LOADING OF In: 0.5 to 1 TIME

### AMOUNT OF LOADING OF In: 1 to 4 TIMES

FIG. 8

AMOUNT OF LOADING OF In: 0.5 to 1 TIME
Ex = 700 nm

AMOUNT OF LOADING OF In: 1 to 4 TIMES
Ex = 700 nm

FIG. 9A

HEATING TIME: 20 MIN

| a/(a+b) = 0.25 | a/(a+b) = 0.5 | a/(a+b) = 0.75 | a/(a+b) = 0.82 |
|---|---|---|---|
| 20 nm | 20 nm | 20 nm | 20 nm |
| AVERAGE PARTICLE SIZE: 2.9±0.5 nm | AVERAGE PARTICLE SIZE: 3.0±0.4 nm | AVERAGE PARTICLE SIZE: 4.0±0.5 nm | AVERAGE PARTICLE SIZE: 6.2±1.2 nm |

| a/(a+b) = 0.88 | a/(a+b) = 0.94 | a/(a+b) = 1 |
|---|---|---|
| 20 nm | 20 nm | 20 nm |
| AVERAGE PARTICLE SIZE: 4.6±0.6 nm | AVERAGE PARTICLE SIZE: 8.7±2.6 nm | AVERAGE PARTICLE SIZE: 5.8±0.8 nm |

FIG. 9B

REACTION TIME: 10 MIN

| a/(a+b) = 0.25 | a/(a+b) = 0.5 |
|---|---|
| 20 nm | 20 nm |
| AVERAGE PARTICLE SIZE: 3.1±0.5 nm | AVERAGE PARTICLE SIZE: 3.0±0.5 nm |
| a/(a+b) = 0.75 | a/(a+b) = 0.88 |
| 20 nm | 20 nm |
| AVERAGE PARTICLE SIZE: 3.1±0.4 nm | AVERAGE PARTICLE SIZE: 3.8±0.7 nm |

EP 4 656 595 A1

# FIG. 10A

## REACTION TIME: 20 MIN, a/(a+b): 0-0.75

## REACTION TIME: 20 MIN, a/(a+b): 0.75-1.0

## FIG. 10B

REACTION TIME: 10 MIN, a/(a+b): 0-0.75

REACTION TIME: 10 MIN, a/(a+b): 0.75-1.0

## FIG. 11A

### REACTION TIME: 20 MIN

## FIG. 11B

REACTION TIME: 10 MIN

FIG. 12

REACTION TIME: 20 MIN

REACTION TIME: 10 MIN

FIG. 13

| REACTION TIME: 5 MIN | REACTION TIME: 10 MIN | REACTION TIME: 15 MIN |
|---|---|---|
| | | |
| AVERAGE PARTICLE SIZE: 2.9 ± 0.5nm | AVERAGE PARTICLE SIZE: 3.1 ± 0.4 nm | AVERAGE PARTICLE SIZE: 5.7 ± 1.9 nm |
| REACTION TIME: 20 MIN | REACTION TIME: 40 MIN | REACTION TIME: 80 MIN |
| | | |
| AVERAGE PARTICLE SIZE: 4.0 ± 0.5 nm | AVERAGE PARTICLE SIZE: 4.1 ± 0.8 nm | AVERAGE PARTICLE SIZE: 4.6 ± 0.6 nm |

# FIG. 14

## REACTION TIME: 5 TO 15 MIN

## REACTION TIME: 15 TO 80 MIN

# FIG. 15

## REACTION TIME: 5 TO 20 MIN

## REACTION TIME: 20 TO 80 MIN

FIG. 16

# EP 4 656 595 A1

## INTERNATIONAL SEARCH REPORT

| International application No. |
|---|
| **PCT/JP2024/001616** |

### A. CLASSIFICATION OF SUBJECT MATTER

*C01B 19/00*(2006.01)i; *B82Y 30/00*(2011.01)i; *C09K 11/58*(2006.01)i; *C09K 11/62*(2006.01)i; *C09K 11/88*(2006.01)i; *H01L 31/0352*(2006.01)i

FI: C01B19/00 Z; C09K11/88; H01L31/04 342A; C09K11/62; C09K11/58; B82Y30/00

According to International Patent Classification (IPC) or to both national classification and IPC

### B. FIELDS SEARCHED

Minimum documentation searched (classification system followed by classification symbols)

C01B19/00; B82Y30/00; C09K11/58; C09K11/62; C09K11/88; H01L31/0352

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

JSTPlus/JMEDPlus/JST7580 (JDreamIII); JSTChina (JDreamIII)

### C. DOCUMENTS CONSIDERED TO BE RELEVANT

| Category* | Citation of document, with indication, where appropriate, of the relevant passages | Relevant to claim No. |
|---|---|---|
| A | EP 4092095 A1 (SUZHOU INSTITUTE OF NANO-TECH AND NANO-BIONICS (SINANO) CHINESE ACADEMY OF SCIENCES) 23 November 2022 (2022-11-23)<br>entire text | 1-10 |
| A | YANG, Hongchao et al. J.Am.Chem.Soc. 2021, vol. 143, no. 6, pp. 2601-2607, doi:10.1021/jacs.0c 13071<br>entire text | 1-10 |
| A | JP 2008-540304 A (TRANSFERT PLUS, S.E.C) 20 November 2008 (2008-11-20)<br>entire text | 1-10 |
| A | JP 2022-48169 A (NATIONAL UNIVERSITY CORPORATION TOKAI NATIONAL HIGHER EDUCATION AND RESEARCH SYSTEM) 25 March 2022 (2022-03-25)<br>entire text | 1-10 |
| A | JP 2018-44142 A (OSAKA UNIVERSITY) 22 March 2018 (2018-03-22)<br>entire text | 1-10 |

| ✓ Further documents are listed in the continuation of Box C. | ✓ See patent family annex. |
|---|---|

| * Special categories of cited documents: | |
|---|---|
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **12 March 2024** | **26 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT

| International application No. |
|---|
| **PCT/JP2024/001616** |

### C. DOCUMENTS CONSIDERED TO BE RELEVANT

| Category* | Citation of document, with indication, where appropriate, of the relevant passages | Relevant to claim No. |
|---|---|---|
| A | JP 2020-522452 A (NEXDOT) 30 July 2020 (2020-07-30)<br>    entire text | 1-10 |
| A | JP 2015-189636 A (NATIONAL UNIVERSITY CORPORATION NAGOYA UNIVERSITY) 02 November 2015 (2015-11-02)<br>    entire text | 1-10 |
| A | JP 2020-33245 A (NATIONAL UNIVERSITY CORPORATION NAGOYA UNIVERSITY) 05 March 2020 (2020-03-05)<br>    entire text | 1-10 |

Form PCT/ISA/210 (second sheet) (July 2022)

INTERNATIONAL SEARCH REPORT
Information on patent family members

International application No.

**PCT/JP2024/001616**

| Patent document cited in search report | | | Publication date (day/month/year) | Patent family member(s) | | | Publication date (day/month/year) |
|---|---|---|---|---|---|---|---|
| EP | 4092095 | A1 | 23 November 2022 | WO 2022-156467 A1 entire text CN 114854416 A | | | |
| JP | 2008-540304 | A | 20 November 2008 | US 2008-0187483 A1 entire text CA 002604495 A | | | |
| JP | 2022-48169 | A | 25 March 2022 | US 2019-0345384 A1 entire text | | | |
| JP | 2018-44142 | A | 22 March 2018 | US 2017-0267924 A1 entire text | | | |
| JP | 2020-522452 | A | 30 July 2020 | US 2018-0348577 A1 entire text CN 110997569 A KR 10-2020-0023295 A | | | |
| JP | 2015-189636 | A | 02 November 2015 | (Family: none) | | | |
| JP | 2020-33245 | A | 05 March 2020 | US 2019-0345384 A1 entire text | | | |

**EP 4 656 595 A1**

**Patent documents cited in the description**

- JP 2004243507 A
- JP 2004352594 A
- JP 2017014476 A
- WO 2020054764 A